# EUROPEAN PATENT APPLICATION

(11) **EP 4 170 001 A1**
(43) Date of publication of application: **26.04.2023**
(21) Application number: 21826650.0
(22) Date of filing: 16.06.2021
(51) Int. Cl.: C09K 11/06, H01L 51/50

(54) **ORGANIC ELECTROLUMINESCENT ELEMENT**

(30) Priority: 19.06.2020 JP 2020105811
(71) Applicant: Hodogaya Chemical Co., Ltd., Tokyo, 105-0021 (JP); SFC Co., Ltd., Cheongju-si, Chungcheongbuk-do 28122 (KR)
(72) Inventor: HIRAYAMA, Yuta, Tokyo 104-0028 (JP); YAMAMOTO, Takeshi, Tokyo 104-0028 (JP); KASE, Kouki, Tokyo 104-0028 (JP); SURUGA, Kazuyuki, Tokyo 104-0028 (JP); HAYASHI, Shuichi, Tokyo 104-0028 (JP); CHA, Soon-Wook, Cheongju-si, Chungcheongbuk-do 28122 (KR); JOO, Sung-Hoon, Cheongju-si, Chungcheongbuk-do 28122 (KR); YANG, Byung-Sun, Cheongju-si, Chungcheongbuk-do 28122 (KR); KIM, Ji-Hwan, Cheongju-si, Chungcheongbuk-do 28122 (KR)
(74) Representative: Forstmeyer, Dietmar
(86) International application number: PCT/JP2021/022894
(87) International publication number: WO 2021/256515

(57) **Abstract**

An objective of the present invention is to provide a material for organic EL devices offering excellent hole injectability and transportability, electron blockability, stability in a thin-film state, and durability, and also to provide an organic EL device having high efficiency, low driving voltage and long lifetime by employing, in combination, the aforementioned material and various materials for organic EL devices offering excellent hole/electron injectability and transportability, electron blockability, stability in a thin-film state, and durability, in a manner that the properties of each of the materials can be brought out effectively. The present invention relates to an organic EL device containing a specific arylamine compound as a material constituting a second hole transport layer, wherein the difference between the HOMO level of the second hole transport layer and the HOMO level of a first hole transport layer is 0.15 eV or less.

## Description

### Technical Field

The present invention relates to an organic electroluminescence device which is a self-luminous light-emitting device suitable for various display devices, and more specifically, to an organic electroluminescence device (abbreviated hereinbelow as "organic EL device") employing a specific arylamine compound.

### Background Art

Organic EL devices, which are self-luminous light-emitting devices, are brighter, have better visibility, and are capable of clearer display compared to liquid crystal devices. Therefore, organic EL devices have been actively researched.

In 1987, C. W. Tang et al. of Eastman Kodak Company developed a device having a multilayer structure wherein various roles for light emission were allotted respectively to different materials, thereby achieving practical utilization of organic EL devices using organic materials. They developed a laminate including a layer of a fluorescent substance capable of transporting electrons and a layer of an organic substance capable of transporting holes. Injecting both charges into the fluorescent substance layer causes emission of light, achieving a high luminance of 1,000 cd/m² or higher at a voltage of 10 V or less (see, for example, Patent Literatures 1 and 2).

Many improvements have been heretofore made for practical utilization of organic EL devices. Further subdivision of the various roles within the multilayer structure has yielded an electroluminescent device wherein an anode, a hole injection layer, a hole transport layer, a light-emitting layer, an electron transport layer, an electron injection layer, and a cathode are formed sequentially on a substrate, achieving high efficiency and high durability (see, for example, Non-Patent Literature 1).

To further improve luminous efficiency, attempts have been made to employ triplet excitons. Also, the use of phosphorescent compounds has been investigated (see, for example, Non-Patent Literature 2). Further, devices employing light emission by thermally activated delayed fluorescence (TADF) have been developed. In 2011, Adachi et al. of Kyushu University achieved an external quantum efficiency of 5.3% with a device using a thermally activated delayed fluorescence material (see, for example, Non-Patent Literature 3).

A light-emitting layer can be prepared by doping a charge-transporting compound, typically called a "host material", with a fluorescent compound, a phosphorescent compound, or a material emitting delayed fluorescence. As described in the aforementioned Non-Patent Literatures, the selection of organic materials in an organic EL device greatly affects various properties such as efficiency and durability of that device (see, for example, Non-Patent Literature 2).

In organic EL devices, charges injected from the respective electrodes recombine in the light-emitting layer to emit light. Thus, what is important is to efficiently deliver the charges, i.e., the holes and electrons, to the light-emitting layer, which requires the device to have excellent carrier balance. By enhancing hole injectability and also enhancing electron blockability for blocking the electrons injected from the cathode, it is possible to increase the probability of hole-electron recombination. Also, by confining excitons generated within the light-emitting layer, high luminous efficiency can be achieved. Therefore, the hole-transporting material serves an important role, and there is thus a demand for a hole-transporting material having high hole injectability, high hole mobility, high electron blockability, and high durability against electrons.

In terms of device longevity, the material's heat resistance and amorphous properties are also important. With a material having poor heat resistance, thermal decomposition and material degradation occur, even at low temperatures, due to heat produced when the device is driven. With a material having poor amorphous properties, a thin film undergoes crystallization in a short time, resulting in device degradation. Thus, the material to be used requires high heat resistance and good amorphous properties.

Examples of known hole-transporting materials used heretofore in organic EL devices include N,N'-diphenyl-N,N'-di(α-naphthyl)-benzidine ("NPD") and various aromatic amine derivatives (see, for example, Patent Literatures 1 and 2). NPD does have good hole transportability, but its glass transition point (Tg), serving as an index of heat resistance, is as low as 96°. This may cause degradation in device properties due to crystallization in high-temperature conditions (see, for example, Non-Patent Literature 4). Further, among the aromatic amine derivatives disclosed in the aforementioned Patent Literatures, there are compounds having excellent mobility, such as hole mobility of 10⁻³ cm²/Vs or greater (see, for example, Patent Literatures 1 and 2). These compounds, however, have insufficient electron blockability, thus allowing a portion of the electrons to pass through the light-emitting layer and thereby making it impossible to expect improvements in luminous efficiency. To achieve even higher efficiency, there is a demand for a material having higher electron blockability and higher heat resistance and providing a more stable thin film. Further, aromatic amine derivatives having high durability have been reported (see, for example, Patent Literature 3), but these compounds are used as charge-transporting materials to be used in electrophotographic photoreceptors, and have never been used in organic EL devices.

Arylamine compounds having a substituted carbazole structure have been proposed as compounds having improved properties such as heat resistance and hole injectability (see, for example, Patent Literatures 4 and 5). Devices using these compounds for the hole injection layer or hole transport layer are improved in terms of heat resistance and luminous efficiency, but these improvements are still insufficient, and there are further demands for even lower driving voltage and higher luminous efficiency.

There is also a demand for devices capable of achieving highly efficient hole-electron recombination and having high luminous efficiency, low driving voltage, and long lifetime, by employing, in combination, materials having excellent hole/electron injectability and transportability, thin film stability and durability, in order to improve the properties of organic EL devices and enhance the yield in producing such devices.

Further, there is also a demand for devices having good carrier balance, high efficiency, low driving voltage, and long lifetime, by employing, in combination, materials having excellent hole/electron injectability and transportability, thin film stability and durability, in order to improve the properties of organic EL devices.

### Citation List

### Patent Literature

Patent Literature 1: US5792557
Patent Literature 2: US5639914
Patent Literature 3: US7799492
Patent Literature 4: US8021764
Patent Literature 5: US8394510
Patent Literature 6: Korean Patent Application Unexamined Publication No. 10-2018-0051356
Patent Literature 7: EP2684932

### Non-Patent Literature

Non-Patent Literature 1: Japan Society of Applied Physics, Preprints for 9th Lecture, pp. 55-61 (2001)
Non-Patent Literature 2: Japan Society of Applied Physics, Preprints for 9th Lecture, pp. 23-31 (2001)
Non-Patent Literature 3: Appl. Phys. Let., 98, 083302 (2011)
Non-Patent Literature 4: Japan OLED Forum, Preprints for 3rd Regular Meeting, pp. 13-14 (2006)

### Summary of Invention

An objective of the present invention is to provide a material for organic EL devices offering excellent hole injectability and transportability, electron blockability, stability in a thin-film state, and durability, and also to provide an organic EL device having high efficiency, low driving voltage and long lifetime by employing, in combination, the aforementioned material and various other materials for organic EL devices offering excellent hole/electron injectability and transportability, electron blockability, stability in a thin-film state, and durability, in a manner that the properties of each of the materials can be brought out effectively.

Examples of physical properties to be possessed by an organic compound employed in an organic EL device provided by the present invention may include: (1) excellent hole injection properties; (2) high hole mobility; (3) excellent stability in a thin-film state; and (4) excellent heat resistance. Further, examples of physical properties to be possessed by an organic EL device provided by the present invention may include: (1) high luminous efficiency and power efficiency; (2) low practical driving voltage; and (3) long lifetime.

To achieve the aforementioned objectives, Inventors focused on the fact that triarylamine compounds have excellent hole injectability and transportability as well as thin film stability and durability, and diligently studied various triarylamine compounds, thus arriving at the finding that, by using a triarylamine compound having a specific structure as a material for a hole transport layer, holes injected from the anode side can be transported efficiently. Inventors have also found that the aforementioned objectives can be achieved by making the hole transport layer into a two-layer structure and providing each layer with a specific construction, thus accomplishing the present invention.

That is, the present invention is an organic EL device described as follows.
{1} An organic electroluminescence device comprising, between an anode and a cathode, at least a first hole transport layer, a second hole transport layer, a light-emitting layer, and an electron transport layer in this order from the anode side. The second hole transport layer contains a triarylamine compound represented by general formula (1) below; and an absolute value of a difference between a HOMO level of the second hole transport layer and a HOMO level of the first hole transport layer is 0.15 eV or less. 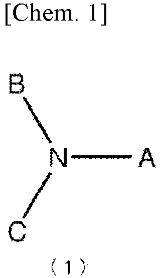
   (In the formula, A represents a group represented by general formula (2-1) below;
   B represents a substituted or unsubstituted aromatic hydrocarbon group, a substituted or unsubstituted aromatic heterocyclic group, or a substituted or unsubstituted fused aromatic group; and
   C represents a group represented by general formula (2-1) below, a substituted or unsubstituted aromatic hydrocarbon group, a substituted or unsubstituted aromatic heterocyclic group, or a substituted or unsubstituted fused aromatic group). 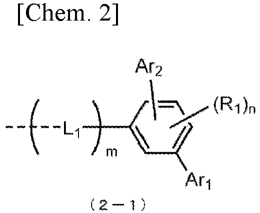
   (In the formula, the broken line represents a bonding site;
   R₁ represents a deuterium atom, a fluorine atom, a chlorine atom, a cyano group, a nitro group, a linear or branched alkyl group having 1 to 6 carbon atoms and optionally having a substituent, a cycloalkyl group having 5 to 10 carbon atoms and optionally having a substituent, a linear or branched alkenyl group having 2 to 6 carbon atoms and optionally having a substituent, a linear or branched alkyloxy group having 1 to 6 carbon atoms and optionally having a substituent, a cycloalkyloxy group having 5 to 10 carbon atoms and optionally having a substituent, a substituted or unsubstituted aromatic hydrocarbon group, a substituted or unsubstituted aromatic heterocyclic group, a substituted or unsubstituted fused polycyclic aromatic group, or a substituted or unsubstituted aryloxy group;
   n is the number of R₁ and represents an integer from 0 to 3, wherein, when n is 2 or 3, R₁ may be the same or different from one another and the plural R₁s may be bonded to each other via a single bond, a substituted or unsubstituted methylene group, an oxygen atom, or a sulfur atom, to form a ring;
   L₁ represents a divalent group which is a substituted or unsubstituted aromatic hydrocarbon, a substituted or unsubstituted aromatic heterocycle, or a substituted or unsubstituted fused polycyclic aromatic;
   m is the number of L₁ and represents an integer from 1 to 3, wherein, when m is 2 or 3, L₁ may be the same or different from one another; and
   An and Ar₂ each independently represent a substituted or unsubstituted aromatic hydrocarbon group, a substituted or unsubstituted aromatic heterocyclic group, or a substituted or unsubstituted fused polycyclic aromatic group.)
{2} The organic electroluminescence device as set forth in clause {1}, wherein the group represented by the general formula (2-1) is a group represented by general formula (2-2) below. 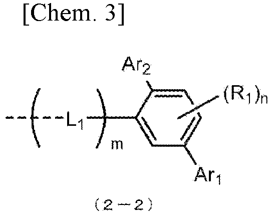 (In the formula, Ar₁, Ar₂, L₁, m, n, and R₁ have same definitions as those in the general formula (2-1).)
{3} The organic electroluminescence device as set forth in clause {1}, wherein the group represented by the general formula (2-1) is a group represented by general formula (2-3) below. 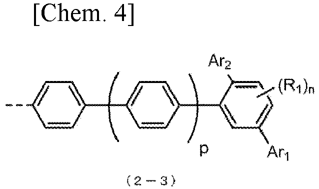
   (In the formula, Ar₁, Ar₂, n, and R₁ have same definitions as those in the general formula (2-1); and
   p represents 0 or 1.)
{4} The organic electroluminescence device as set forth in clause {1}, wherein the group represented by the general formula (2-1) is a group represented by general formula (2-4) below. 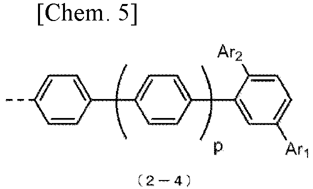
   (In the formula, Ar₁ and Ar₂ have same definitions as those in the general formula (2-1); and
   p represents 0 or 1.)
{5} The organic electroluminescence device as set forth in any one of clauses {1} to {4}, wherein the first hole transport layer contains a triarylamine compound represented by general formula (3). 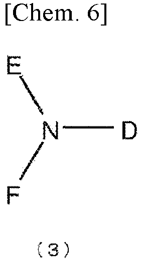
   (In the formula, D, E, and F each independently represent a group represented by general formula (4-1) below, a substituted or unsubstituted aromatic hydrocarbon group, a substituted or unsubstituted aromatic heterocyclic group, or a substituted or unsubstituted fused polycyclic aromatic group, wherein at least one of D, E, and F is a group represented by general formula (4-1) below.) 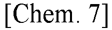 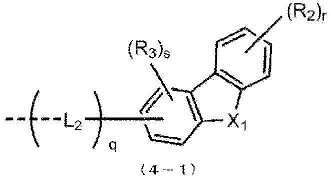
   (In the formula, the broken line represents a bonding site;
   L₂ represents a divalent group which is a substituted or unsubstituted aromatic hydrocarbon, a substituted or unsubstituted aromatic heterocycle, or a substituted or unsubstituted fused polycyclic aromatic;
   q represents an integer from 0 to 3, wherein, when q is 2 or 3, L₂ may be the same or different from one another;
   R₂ and R₃ each independently represent a deuterium atom, a fluorine atom, a chlorine atom, a cyano group, a nitro group, a linear or branched alkyl group having 1 to 6 carbon atoms and optionally having a substituent, a cycloalkyl group having 5 to 10 carbon atoms and optionally having a substituent, a linear or branched alkenyl group having 2 to 6 carbon atoms and optionally having a substituent, a linear or branched alkyloxy group having 1 to 6 carbon atoms and optionally having a substituent, a cycloalkyloxy group having 5 to 10 carbon atoms and optionally having a substituent, a substituted or unsubstituted aromatic hydrocarbon group, a substituted or unsubstituted aromatic heterocyclic group, a substituted or unsubstituted fused polycyclic aromatic group, or a substituted or unsubstituted aryloxy group;
   r represents an integer from 0 to 4 and s represents an integer from 0 to 3, wherein, when r is from 2 to 4, R₂ may be the same or different from one another, when s is 2 or 3, R₃ may be the same or different from one another, and the plural R₂s, the plural R₃s, or the R₂ and the R₃ may be bonded to each other via a single bond, a substituted or unsubstituted methylene group, an oxygen atom, or a sulfur atom, to form a ring;
   X₁ represents O, S, NR₄, or CR₅R₆, wherein, when two or more of D, E, and F are the group represented by general formula (4-1), X₁ may be the same or different from one another;
   R₄ represents a deuterium atom, a fluorine atom, a chlorine atom, a cyano group, a nitro group, a linear or branched alkyl group having 1 to 6 carbon atoms and optionally having a substituent, a cycloalkyl group having 5 to 10 carbon atoms and optionally having a substituent, a linear or branched alkenyl group having 2 to 6 carbon atoms and optionally having a substituent, a linear or branched alkyloxy group having 1 to 6 carbon atoms and optionally having a substituent, a cycloalkyloxy group having 5 to 10 carbon atoms and optionally having a substituent, a substituted or unsubstituted aromatic hydrocarbon group, a substituted or unsubstituted aromatic heterocyclic group, a substituted or unsubstituted fused polycyclic aromatic group, or a substituted or unsubstituted aryloxy group; and
   R₅ and R₆ each independently represent a linear or branched alkyl group having 1 to 6 carbon atoms and optionally having a substituent, a cycloalkyl group having 5 to 10 carbon atoms and optionally having a substituent, a linear or branched alkenyl group having 2 to 6 carbon atoms and optionally having a substituent, a substituted or unsubstituted aromatic hydrocarbon group, a substituted or unsubstituted aromatic heterocyclic group, a substituted or unsubstituted fused polycyclic aromatic group, or a substituted or unsubstituted aryloxy group, wherein the R₅ and the R₆ may be bonded to each other via a single bond, a substituted or unsubstituted methylene group, an oxygen atom, or a sulfur atom, to form a ring.)
{6} The organic electroluminescence device as set forth in clause {5}, wherein two of the D, E, and F in the general formula (3) are groups represented by the general formula (4-1), and the plural X₁s each independently represent said NR₄ or CR₅R₆.
{7} The organic electroluminescence device as set forth in clause {5}, wherein two of the D, E, and F in the general formula (3) are groups represented by the general formula (4-1), and one of the plural X₁s is said NR₄ and the other X₁ is said CR₅R₆.
{8} The organic electroluminescence device as set forth in any one of clauses { 1 } to {7}, wherein the light-emitting layer contains a blue light-emitting dopant.
{9} The organic electroluminescence device as set forth in clause {8}, wherein the blue light-emitting dopant is a compound represented by general formula (5-1) or (5-2) below. 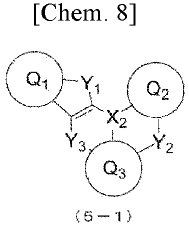 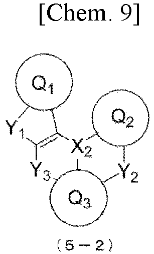
   (In formulas (5-1) and (5-2), Q₁, Q₂, and Q₃ each independently represent a substituted or unsubstituted aromatic hydrocarbon or a substituted or unsubstituted aromatic heterocycle;
   X₂ represents B, P, P=O, or P=S;
   Y₁, Y₂, and Y₃ each independently represent N-R₇, C-R₈R₉, O, S, Se, or Si-R₁₀R₁₁;
   R₇, R₈, R₉, R₁₀, and R₁₁ each independently represent a hydrogen atom, a deuterium atom, a fluorine atom, a chlorine atom, a cyano group, a nitro group, a linear or branched alkyl group having 1 to 6 carbon atoms and optionally having a substituent, a cycloalkyl group having 5 to 10 carbon atoms and optionally having a substituent, a linear or branched alkenyl group having 2 to 6 carbon atoms and optionally having a substituent, a linear or branched alkyloxy group having 1 to 6 carbon atoms and optionally having a substituent, a cycloalkyloxy group having 5 to 10 carbon atoms and optionally having a substituent, a substituted or unsubstituted aromatic hydrocarbon group, a substituted or unsubstituted aromatic heterocyclic group, or a substituted or unsubstituted aryloxy group, wherein R₈ and R₉, as well as R₁₀ and R₁₁, may be bonded to each other via a single bond, a substituted or unsubstituted methylene group, an oxygen atom, a sulfur atom, or a monosubstituted amino group, to form a ring;
   when Y₁ is N-R₇, C-R₈R₉, or Si-R₁₀R₁₁, R₇, R₈, R₉, R₁₀, and R₁₁ may be bonded to Q₁ via a single bond, a substituted or unsubstituted methylene group, an oxygen atom, a sulfur atom, or a monosubstituted amino group, to form a ring;
   when Y₂ is N-R₇, C-R₈R₉, or Si-R₁₀R₁₁, R₇, R₈, R₉, R₁₀, and R₁₁ may be bonded to Q₂ or Q₃ via a single bond, a substituted or unsubstituted methylene group, an oxygen atom, a sulfur atom, or a monosubstituted amino group, to form a ring; and
   when Y₃ is N-R₇, C-R₈R₉, or Si-R₁₀R₁₁, R₇, R₈, R₉, R₁₀, and R₁₁ may be bonded to Q₃ via a single bond, a substituted or unsubstituted methylene group, an oxygen atom, a sulfur atom, or a monosubstituted amino group, to form a ring.)
{10} The organic electroluminescence device as set forth in any one of clauses {1} to {9}, wherein the light-emitting layer contains an anthracene derivative having an anthracene backbone.

Concrete examples of the "aromatic hydrocarbon group", "aromatic heterocyclic group", or "fused polycyclic aromatic group" in the "substituted or unsubstituted aromatic hydrocarbon group", "substituted or unsubstituted aromatic heterocyclic group", or "substituted or unsubstituted fused polycyclic aromatic group" as represented by R₁ to R₆ in general formulas (2-1) to (2-3) and (4-1) may include a phenyl group, a biphenylyl group, a terphenylyl group, a naphthyl group, an anthracenyl group, a phenanthrenyl group, a fluorenyl group, a spirobifluorenyl group, an indenyl group, a pyrenyl group, a perylenyl group, a fluoranthenyl group, a triphenylenyl group, a pyridyl group, a pyrimidinyl group, a triazinyl group, a furyl group, a pyrrolyl group, a thienyl group, a quinolyl group, an isoquinolyl group, a benzofuranyl group, a benzothienyl group, an indolyl group, a carbazolyl group, a benzoxazolyl group, a benzothiazolyl group, a quinoxalinyl group, a benzimidazolyl group, a pyrazolyl group, a dibenzofuranyl group, a dibenzothienyl group, a naphthyridinyl group, a phenanthrolinyl group, an acridinyl group, a carbolinyl group, etc., or may be selected from aryl groups having 6 to 30 carbon atoms or hetero aryl groups having 2 to 30 carbon atoms. The substituent(s) and the substituted benzene ring, or a plurality of substituents substituting the same benzene ring, may be bonded to each other via a single bond, a substituted or unsubstituted methylene group, a substituted or unsubstituted amine group, an oxygen atom, or a sulfur atom, to form a ring.

Concrete examples of the "aryloxy group" in the "substituted or unsubstituted aryloxy group" as represented by R₁ to R₆ in general formulas (2-1) to (2-3) and (4-1) may include a phenyloxy group, a biphenylyloxy group, a terphenylyloxy group, a naphthyloxy group, an anthracenyloxy group, a phenanthrenyloxy group, a fluorenyloxy group, an indenyloxy group, a pyrenyloxy group, a perylenyloxy group, etc.

Concrete examples of the "linear or branched alkyl group having 1 to 6 carbon atoms", "cycloalkyl group having 5 to 10 carbon atoms", or "linear or branched alkenyl group having 2 to 6 carbon atoms" in the "linear or branched alkyl group having 1 to 6 carbon atoms and optionally having a substituent", "cycloalkyl group having 5 to 10 carbon atoms and optionally having a substituent", or "linear or branched alkenyl group having 2 to 6 carbon atoms and optionally having a substituent" as represented by R₁ to R₆ in general formulas (2-1) to (2-3) and (4-1) may include a methyl group, an ethyl group, a n-propyl group, an isopropyl group, a n-butyl group, an isobutyl group, a tert-butyl group, a n-pentyl group, an isopentyl group, a neopentyl group, a n-hexyl group, a cyclopentyl group, a cyclohexyl group, a 1-adamantyl group, a 2-adamantyl group, a vinyl group, an allyl group, an isopropenyl group, a 2-butenyl group, etc. The substituent(s) and the substituted benzene ring, or a plurality of substituents substituting the same benzene ring, may be bonded to each other via a single bond, a substituted or unsubstituted methylene group, a substituted or unsubstituted amine group, an oxygen atom, or a sulfur atom, to form a ring.

Concrete examples of the "linear or branched alkyloxy group having 1 to 6 carbon atoms" or "cycloalkyloxy group having 5 to 10 carbon atoms" in the "linear or branched alkyloxy group having 1 to 6 carbon atoms and optionally having a substituent" or "cycloalkyloxy group having 5 to 10 carbon atoms and optionally having a substituent" as represented by R₁ to R₄ in general formulas (2-1) to (2-3) and (4-1) may include a methyloxy group, an ethyloxy group, a n-propyloxy group, an isopropyloxy group, a n-butyloxy group, a tert-butyloxy group, a n-pentyloxy group, a n-hexyloxy group, a cyclopentyloxy group, a cyclohexyloxy group, a cycloheptyloxy group, a cyclooctyloxy group, a 1-adamantyloxy group, a 2-adamantyloxy group, etc. The aforementioned substituent(s) and the substituted benzene ring, or a plurality of substituents substituting the same benzene ring, may be bonded to each other via a single bond, a substituted or unsubstituted methylene group, a substituted or unsubstituted amine group, an oxygen atom, or a sulfur atom, to form a ring.

Concrete examples of the "substituent" in the "substituted aromatic hydrocarbon group", "substituted aromatic heterocyclic group", "substituted fused polycyclic aromatic group", "substituted aryloxy group", "linear or branched alkyl group having 1 to 6 carbon atoms and optionally having a substituent", "cycloalkyl group having 5 to 10 carbon atoms and optionally having a substituent", "linear or branched alkenyl group having 2 to 6 carbon atoms and optionally having a substituent", "linear or branched alkyloxy group having 1 to 6 carbon atoms and optionally having a substituent", or "cycloalkyloxy group having 5 to 10 carbon atoms and optionally having a substituent" as represented by R₁ to R₆ in general formulas (2-1) to (2-3) and (4-1) may include: a deuterium atom; a cyano group; a nitro group; halogen atoms, such as a fluorine atom, a chlorine atom, a bromine atom, or an iodine atom; silyl groups, such as a trimethylsilyl group, triphenylsilyl group, etc.; linear or branched alkyl groups having 1 to 6 carbon atoms, such as a methyl group, an ethyl group, a propyl group, etc.; linear or branched alkyloxy groups having 1 to 6 carbon atoms, such as a methyloxy group, an ethyloxy group, a propyloxy group, etc.; alkenyl groups, such as a vinyl group, an allyl group, etc.; aryloxy groups, such as a phenyloxy group, a tolyloxy group, etc.; arylalkyloxy groups, such as a benzyloxy group, a phenethyloxy group, etc.; aromatic hydrocarbon groups or fused polycyclic aromatic groups, such as a phenyl group, a biphenylyl group, a terphenylyl group, a naphthyl group, an anthracenyl group, a phenanthrenyl group, a fluorenyl group, a spirobifluorenyl group, an indenyl group, a pyrenyl group, a perylenyl group, a fluoranthenyl group, a triphenylenyl group, etc.; and aromatic heterocyclic groups, such as a pyridyl group, a thienyl group, a furyl group, a pyrrolyl group, a quinolyl group, an isoquinolyl group, a benzofuranyl group, a benzothienyl group, an indolyl group, a carbazolyl group, a benzoxazolyl group, a benzothiazolyl group, a quinoxalinyl group, a benzimidazolyl group, a pyrazolyl group, a dibenzofuranyl group, a dibenzothienyl group, a carbolinyl group, etc. These substituents may further be substituted by any of the substituents given as examples above. Further, the aforementioned substituent(s) and the substituted benzene ring, or a plurality of substituents substituting the same benzene ring, may be bonded to each other via a single bond, a substituted or unsubstituted methylene group, a substituted or unsubstituted amine group, an oxygen atom, or a sulfur atom, to form a ring.

Examples of the "aromatic hydrocarbon group", "aromatic heterocyclic group", or "fused polycyclic aromatic group" in the "substituted or unsubstituted aromatic hydrocarbon group", "substituted or unsubstituted aromatic heterocyclic group" or "substituted or unsubstituted fused polycyclic aromatic group" as represented by An and Ar₂ in general formulas (2-1) to (2-4) may include the aforementioned examples given for the "aromatic hydrocarbon group", "aromatic heterocyclic group" or "fused polycyclic aromatic group" as represented by R₁ to R₆ in the general formulas (2-1) to (2-3) and (4-1), and they may take similar forms/configurations as those described above.

Examples of the "substituent" in the "substituted aromatic hydrocarbon group", "substituted aromatic heterocyclic group", or "substituted fused polycyclic aromatic group" as represented by Ar₁ and Ar₂ in general formulas (2-1) to (2-4) may include the aforementioned examples given for the "substituent" represented by R₁ to R₆ in the general formulas (2-1) to (2-3) and (4-1), and they may take similar forms/configurations as those described above.

Examples of the "aromatic hydrocarbon group", "aromatic heterocyclic group", or "fused polycyclic aromatic group" in the "substituted or unsubstituted aromatic hydrocarbon group", "substituted or unsubstituted aromatic heterocyclic group" or "substituted or unsubstituted fused polycyclic aromatic group" as represented by B and C in general formula (1) and by D, E, and F in general formula (3) may include the aforementioned examples given for the "aromatic hydrocarbon group", "aromatic heterocyclic group", or "fused polycyclic aromatic group" as represented by R₁ to R₆ in the general formulas (2-1) to (2-3) and (4-1), and they may take similar forms/configurations as those described above.

Examples of the "substituent" in the "substituted aromatic hydrocarbon group", "substituted aromatic heterocyclic group", or "substituted fused polycyclic aromatic group" as represented by B and C in general formula (1) and by D, E, and F in general formula (3) may include the aforementioned examples given for the "substituent" represented by R₁ to R₆ in the general formulas (2-1) to (2-3) and (4-1), and they may take similar forms/configurations as those described above.

Concrete examples of the "aromatic hydrocarbon", "aromatic heterocycle", or "fused polycyclic aromatic" of the "substituted or unsubstituted aromatic hydrocarbon", "substituted or unsubstituted aromatic heterocycle", or "substituted or unsubstituted fused polycyclic aromatic" in the "divalent group of a substituted or unsubstituted aromatic hydrocarbon or of a substituted or unsubstituted aromatic heterocycle or of a substituted or unsubstituted fused polycyclic aromatic" as represented by L₁ and L₂ in general formulas (2-1), (2-2), and (4-1) may include benzene, biphenyl, terphenyl, tetrakisphenyl, styrene, naphthalene, anthracene, acenaphthalene, fluorene, phenanthrene, indan, pyrene, triphenylene, pyridine, pyrimidine, triazine, pyrrole, furan, thiophen, quinoline, isoquinoline, benzofuran, benzothiophen, indoline, carbazole, carboline, benzoxazole, benzothiazole, quinoxaline, benzoimidazole, pyrazole, dibenzofuran, dibenzothiophen, naphthyridine, phenanthroline, acridine, etc.

The "divalent group of a substituted or unsubstituted aromatic hydrocarbon or of a substituted or unsubstituted aromatic heterocycle or of a substituted or unsubstituted fused polycyclic aromatic" represented by L₁ and L₂ in general formulas (2-1), (2-2), and (4-1) represents a divalent group that can be obtained by removing two hydrogen atoms from the aforementioned "aromatic hydrocarbon", "aromatic heterocycle", or "fused polycyclic aromatic". These divalent groups may have a substituent, and examples of the "substituent" may include the aforementioned examples given for the "substituent" represented by R₁ to R₆ in the general formulas (2-1) to (2-3) and (4-1), and they may take similar forms/configurations as those described above.

From the viewpoint of hole injectability and transportability, it is preferable that the monovalent group represented by general formula (2-1) is preferably a group represented by general formula (2-2), more preferably a group represented by general formula (2-3), and even more preferably a group represented by general formula (2-4).

From the viewpoint of hole injectability and transportability, it is preferable that, in groups represented by general formulas (2-1) to (2-4), Ar₁ and Ar₂ are preferably a substituted or unsubstituted aromatic hydrocarbon group or a substituted or unsubstituted fused polycyclic aromatic group, and more preferably a substituted or unsubstituted phenyl group, a substituted or unsubstituted naphthyl group, or a substituted or unsubstituted biphenylyl group, and even more preferably an unsubstituted phenyl group or an unsubstituted naphthyl group.

In the triarylamine compound represented by general formula (1), from the viewpoint of hole injectability and transportability, it is preferable that B and C each independently represent a substituted or unsubstituted aromatic hydrocarbon group or a substituted or unsubstituted fused aromatic group, and more preferably a substituted or unsubstituted phenyl group, a substituted or unsubstituted naphthyl group, a substituted or unsubstituted phenanthrenyl group, or a substituted or unsubstituted fluorenyl group.

In the group represented by general formula (4-1), from the viewpoint of hole injectability and transportability, it is preferable that X₁ is NR₄ or CR₅R₆, and more preferably CR₅R₆. It is even more preferable that R₅ and R₆ each independently represent a linear or branched alkyl group having 1 to 6 carbon atoms and optionally having a substituent or a substituted or unsubstituted aromatic hydrocarbon group, and more preferably a linear alkyl group having 1 to 6 carbon atoms or an unsubstituted aromatic hydrocarbon group, and even more preferably a linear alkyl group having 1 to 4 carbon atoms or an unsubstituted phenyl group.

In the group represented by general formula (4-1), from the viewpoint of hole injectability and transportability, it is preferable that r and s are both 0. It is also preferable that L₂ is a phenylene group, and q is preferably 0 or 1.

In the triarylamine compound represented by general formula (3), from the viewpoint of hole injectability and transportability, it is preferable that two of D, E, and F are a group represented by general formula (4-1). In this case, it is preferable that the two X₁s each independently represent NR₄ or CR₅R₆, and more preferably, the two X₁s are both CR₅R₆.

In the triarylamine compound represented by general formula (3), from the viewpoint of hole injectability and transportability, it is preferable that, among D, E and F, the group(s) other than the group represented by the general formula (4-1) each independently represent(s) a substituted or unsubstituted aromatic hydrocarbon group or a substituted or unsubstituted fused aromatic group, and more preferably a substituted or unsubstituted phenyl group, a substituted or unsubstituted naphthyl group, or a substituted or unsubstituted biphenylyl group.

Concrete examples of the "aromatic hydrocarbon" or "aromatic heterocycle" in the "substituted or unsubstituted aromatic hydrocarbon" or "substituted or unsubstituted aromatic heterocycle" represented by Q₁ to Q₃ in general formulas (5-1) and (5-2) may include benzene, naphthalene, anthracene, fluorene, phenanthrene, pyridine, pyrimidine, triazine, pyrrole, furan, thiophen, quinoline, isoquinoline, indene, benzofuran, benzothiophen, indole, indoline, carbazole, carboline, benzoxazole, benzothiazole, quinoxaline, benzoimidazole, pyrazole, dibenzofuran, dibenzothiophen, naphthyridine, phenanthroline, acridine, etc.

The above may have a substituent, and examples of the substituent may include the aforementioned examples given for the "substituent" in the "linear or branched alkyl group having 1 to 6 carbon atoms and having a substituent", "cycloalkyl group having 5 to 10 carbon atoms and having a substituent", or "linear or branched alkenyl group having 2 to 6 carbon atoms and having a substituent" as represented by R₁ to R₆ in the general formulas (2-1) to (2-3) and (4-1). These substituents may be bonded to each other via a single bond, a substituted or unsubstituted methylene group, an oxygen atom, or a sulfur atom, to form a ring.

X₂ in general formulas (5-1) and (5-2) represents B, P, P=O, or P=S. B represents a boron atom, P represents a phosphorus atom, P=O represents a phosphorus atom forming a double bond with an oxygen atom, and P=S represents a phosphorus atom forming a double bond with a sulfur atom.

Y₁ to Y₃ in general formulas (5-1) and (5-2) each independently represent N-R₇, C-R₈R₉, O, S, Se, or Si-R₁₀R₁₁. N-R₇ represents a nitrogen atom having R₇ as a substituent, C-R₈R₉ represents a carbon atom having R₈ and R₉ as substituents, O represents an oxygen atom, S represents a sulfur atom, Se represents a selenium atom, and Si-R₁₀R₁₁ represents a silicon atom having R₁₀ and R₁₁ as substituents.

Concrete examples of the "linear or branched alkyl group having 1 to 6 carbon atoms", "cycloalkyl group having 5 to 10 carbon atoms", or "linear or branched alkenyl group having 2 to 6 carbon atoms" in the "linear or branched alkyl group having 1 to 6 carbon atoms and optionally having a substituent", "cycloalkyl group having 5 to 10 carbon atoms and optionally having a substituent", or "linear or branched alkenyl group having 2 to 6 carbon atoms and optionally having a substituent" as represented by R₇ to R₁₁ in the general formulas (5-1) and (5-2) may include a methyl group, an ethyl group, a n-propyl group, an isopropyl group, a n-butyl group, an isobutyl group, a tert-butyl group, a n-pentyl group, an isopentyl group, a neopentyl group, a n-hexyl group, a cyclopentyl group, a cyclohexyl group, a 1-adamantyl group, a 2-adamantyl group, a vinyl group, an allyl group, an isopropenyl group, a 2-butenyl group, etc. The above may have a substituent, and examples of the substituent may include the aforementioned examples given for the "substituent" in the "linear or branched alkyl group having 1 to 6 carbon atoms and having a substituent", "cycloalkyl group having 5 to 10 carbon atoms and having a substituent", or "linear or branched alkenyl group having 2 to 6 carbon atoms and having a substituent" as represented by R₁ to R₆ in the general formulas (2-1) to (2-3) and (4-1).

Concrete examples of the "linear or branched alkyloxy group having 1 to 6 carbon atoms" or "cycloalkyloxy group having 5 to 10 carbon atoms" in the "linear or branched alkyloxy group having 1 to 6 carbon atoms and optionally having a substituent" or "cycloalkyloxy group having 5 to 10 carbon atoms and optionally having a substituent" as represented by R₇ to R₁₁ in the general formulas (5-1) and (5-2) may include a methyloxy group, an ethyloxy group, a n-propyloxy group, an isopropyloxy group, a n-butyloxy group, a tert-butyloxy group, a n-pentyloxy group, a n-hexyloxy group, a cyclopentyloxy group, a cyclohexyloxy group, a cycloheptyloxy group, a cyclooctyloxy group, a 1-adamantyloxy group, a 2-adamantyloxy group, etc. These groups may have a substituent, and examples of the substituent may include the aforementioned examples given for the "substituent" in the "linear or branched alkyl group having 1 to 6 carbon atoms and having a substituent", "cycloalkyl group having 5 to 10 carbon atoms and having a substituent", or "linear or branched alkenyl group having 2 to 6 carbon atoms and having a substituent" as represented by R₁ to R₆ in the general formulas (2-1) to (2-3) and (4-1).

Concrete examples of the "aromatic hydrocarbon group" or "aromatic heterocyclic group" in the "substituted or unsubstituted aromatic hydrocarbon group" or "substituted or unsubstituted aromatic heterocyclic group" as represented by R₇ to R₁₁ in the general formulas (5-1) and (5-2) may include a phenyl group, a biphenylyl group, a terphenylyl group, a naphthyl group, an anthracenyl group, a phenanthrenyl group, a pyridyl group, a pyrimidinyl group, a triazinyl group, a furyl group, a pyrrolyl group, a thienyl group, etc. These groups may have a substituent, and examples of the substituent may include the aforementioned examples given for the "substituent" in the "linear or branched alkyl group having 1 to 6 carbon atoms and having a substituent", "cycloalkyl group having 5 to 10 carbon atoms and having a substituent", or "linear or branched alkenyl group having 2 to 6 carbon atoms and having a substituent" as represented by R₁ to R₆ in the general formulas (2-1) to (2-3) and (4-1).

Concrete examples of the "aryloxy group" in the "substituted or unsubstituted aryloxy group" as represented by R₇ to R₁₁ in the general formulas (5-1) and (5-2) may include a phenyloxy group, a biphenylyloxy group, a terphenylyloxy group, a naphthyloxy group, an anthracenyloxy group, a phenanthrenyloxy group, a fluorenyloxy group, an indenyloxy group, a pyrenyloxy group, a perylenyloxy group, etc. These groups may have a substituent, and examples of the substituent may include the aforementioned examples given for the "substituent" in the "linear or branched alkyl group having 1 to 6 carbon atoms and having a substituent", "cycloalkyl group having 5 to 10 carbon atoms and having a substituent", or "linear or branched alkenyl group having 2 to 6 carbon atoms and having a substituent" as represented by R₁ to R₆ in the general formulas (2-1) to (2-3) and (4-1).

In compounds represented by general formulas (5-1) and (5-2), from the viewpoint of luminous efficiency, it is preferable that the "aromatic hydrocarbon" or "aromatic heterocycle" in the "substituted or unsubstituted aromatic hydrocarbon" or "substituted or unsubstituted aromatic heterocycle" as represented by Q₁ to Q₃ is benzene, naphthalene, phenanthrene, pyridine, pyrimidine, indene, benzofuran, benzothiophen, or indole, and more preferably benzene or naphthalene.

In compounds represented by general formulas (5-1) and (5-2), from the viewpoint of luminous efficiency, it is preferable that Y₁ is N-R₇, O, or S, and more preferably O or S. Further, in the compound represented by the general formula (5-1), from the viewpoint of luminous efficiency, it is preferable that at least one of Y₂ and Y₃ is N-R₇, and more preferably, both are N-R₇. R₇ is preferably a "substituted or unsubstituted aromatic hydrocarbon group", and more preferably a phenyl group, a biphenylyl group, a terphenylyl group or naphthyl group, either substituted or unsubstituted.

Examples of compounds represented by the general formulas (5-1) and (5-2) may preferably include compounds represented by general formulas (5-3) to (5-6) below. 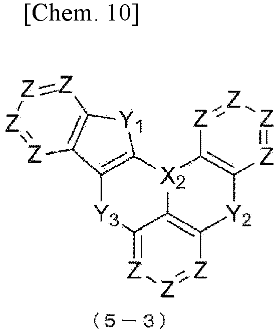 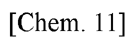 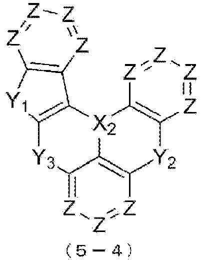 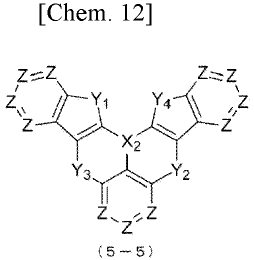 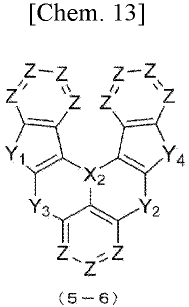
(In formulas (5-3) to (5-6), X₂, Y₁, Y₂, and Y₃ have same definitions as those in the general formulas (5-1) and (5-2);
Y₄ is any one selected from N-R₇, C-R₈R₉, O, S, Se, or Si-R₁₀R₁₁;
R₇, R₈, R₉, R₁₀, and R₁₁ have same definitions as those in the general formulas (5-1) and (5-2);
Z may be the same or different from one another, and is each CR₁₂ or N; and
R₁₂ may be the same or different from one another, and is each a hydrogen atom, a deuterium atom, a halogen group, a cyano group, a nitro group, a linear or branched alkyl group having 1 to 6 carbon atoms and optionally having a substituent, a cycloalkyl group having 5 to 10 carbon atoms and optionally having a substituent, a linear or branched alkyloxy group having 1 to 6 carbon atoms and optionally having a substituent, a linear or branched alkylthioxy group having 1 to 6 carbon atoms and optionally having a substituent, a linear or branched alkylamine group having 1 to 6 carbon atoms and optionally having a substituent, a linear or branched alkylsilyl group having 3 to 10 carbon atoms and optionally having a substituent, a substituted or unsubstituted aromatic hydrocarbon group, a substituted or unsubstituted aromatic heterocyclic group, a substituted or unsubstituted aryloxy group, a substituted or unsubstituted arylthioxy group, a substituted or unsubstituted arylamine group, or a substituted or unsubstituted arylsilyl group, wherein the R₁₂ groups may be bonded to each other, or R₁₂ may be bonded with an adjacent substituent, to form an alicyclic or aromatic monocyclic or polycyclic ring, and the carbon atom(s) in the alicyclic or aromatic monocyclic or polycyclic ring may optionally be substituted by one or a plurality of heteroatoms selected from N, S, and O.)

Concrete examples of the "linear or branched alkyl group having 1 to 6 carbon atoms" or "cycloalkyl group having 5 to 10 carbon atoms" in the "linear or branched alkyl group having 1 to 6 carbon atoms and optionally having a substituent" or "cycloalkyl group having 5 to 10 carbon atoms and optionally having a substituent" as represented by R₁₂ in general formulas (5-3) to (5-6) may include a methyl group, an ethyl group, a n-propyl group, an isopropyl group, a n-butyl group, an isobutyl group, a tert-butyl group, a n-pentyl group, an isopentyl group, a neopentyl group, a n-hexyl group, a cyclopentyl group, a cyclohexyl group, a 1-adamantyl group, a 2-adamantyl group, etc. The above may have a substituent, and examples of the substituent may include the aforementioned examples given for the "substituent" in the "linear or branched alkyl group having 1 to 6 carbon atoms and having a substituent", "cycloalkyl group having 5 to 10 carbon atoms and having a substituent", or "linear or branched alkenyl group having 2 to 6 carbon atoms and having a substituent" as represented by R₁ to R₆ in the general formulas (2-1) to (2-3) and (4-1).

Concrete examples of the "linear or branched alkyloxy group having 1 to 6 carbon atoms" in the "linear or branched alkyloxy group having 1 to 6 carbon atoms and optionally having a substituent" as represented by R₁₂ in general formulas (5-3) to (5-6) may include a methyloxy group, an ethyloxy group, a n-propyloxy group, an isopropyloxy group, a n-butyloxy group, a tert-butyloxy group, a n-pentyloxy group, a n-hexyloxy group, etc. These groups may have a substituent, and examples of the substituent may include the aforementioned examples given for the "substituent" in the "linear or branched alkyl group having 1 to 6 carbon atoms and having a substituent", "cycloalkyl group having 5 to 10 carbon atoms and having a substituent", or "linear or branched alkenyl group having 2 to 6 carbon atoms and having a substituent" as represented by R₁ to R₆ in the general formulas (2-1) to (2-3) and (4-1).

Concrete examples of the "linear or branched alkylthioxy group having 1 to 6 carbon atoms" in the "linear or branched alkylthioxy group having 1 to 6 carbon atoms and optionally having a substituent" as represented by R₁₂ in general formulas (5-3) to (5-6) may include a methylthioxy group, an ethylthioxy group, a n-propylthioxy group, an isopropylthioxy group, a n-butylthioxy group, an isobutylthioxy group, a tert-butylthioxy group, a n-pentylthioxy group, an isopentylthioxy group, a neopentylthioxy group, a n-hexylthioxy group, etc. The above may have a substituent, and examples of the substituent may include the aforementioned examples given for the "substituent" in the "linear or branched alkyl group having 1 to 6 carbon atoms and having a substituent", "cycloalkyl group having 5 to 10 carbon atoms and having a substituent", or "linear or branched alkenyl group having 2 to 6 carbon atoms and having a substituent" as represented by R₁ to R₆ in the general formulas (2-1) to (2-3) and (4-1).

Concrete examples of the "linear or branched alkylamine group having 1 to 6 carbon atoms" in the "linear or branched alkylamine group having 1 to 6 carbon atoms and optionally having a substituent" as represented by R₁₂ in general formulas (5-3) to (5-6) may include a methylamine group, a dimethylamine group, an ethylamine group, a diethylamine group, a n-propylamine group, a di-n-propylamine group, an isopropylamine group, a diisopropylamine group, a n-butylamine group, an isobutylamine group, a tert-butylamine group, a n-pentylamine group, an isopentylamine group, a neopentylamine group, a n-hexylamine group, etc. The above may have a substituent, and examples of the substituent may include the aforementioned examples given for the "substituent" in the "linear or branched alkyl group having 1 to 6 carbon atoms and having a substituent", "cycloalkyl group having 5 to 10 carbon atoms and having a substituent", or "linear or branched alkenyl group having 2 to 6 carbon atoms and having a substituent" as represented by R₁ to R₆ in the general formulas (2-1) to (2-3) and (4-1).

Concrete examples of the "linear or branched alkylsilyl group having 3 to 10 carbon atoms" in the "linear or branched alkylsilyl group having 3 to 10 carbon atoms and optionally having a substituent" as represented by R₁₂ in general formulas (5-3) to (5-6) may include a trimethylsilyl group, a triethylsilyl group, a tri-n-propylsilyl group, a triisopropylsilyl group, a n-butyldimethylsilyl group, an isobutyldimethylsilyl group, a tertbutyldimethylsilyl group, etc. The above may have a substituent, and examples of the substituent may include the aforementioned examples given for the "substituent" in the "linear or branched alkyl group having 1 to 6 carbon atoms and having a substituent", "cycloalkyl group having 5 to 10 carbon atoms and having a substituent", or "linear or branched alkenyl group having 2 to 6 carbon atoms and having a substituent" as represented by R₁ to R₆ in the general formulas (2-1) to (2-3) and (4-1).

Concrete examples of the "aromatic hydrocarbon group" or "aromatic heterocyclic group" in the "substituted or unsubstituted aromatic hydrocarbon group" or "substituted or unsubstituted aromatic heterocyclic group" as represented by R₁₂ in general formulas (5-3) to (5-6) may include a phenyl group, a biphenylyl group, a terphenylyl group, a naphthyl group, an anthracenyl group, a phenanthrenyl group, a pyridyl group, a pyrimidinyl group, a triazinyl group, a furyl group, a pyrrolyl group, a thienyl group, etc. The above may have a substituent, and examples of the substituent may include the aforementioned examples given for the "substituent" in the "linear or branched alkyl group having 1 to 6 carbon atoms and having a substituent", "cycloalkyl group having 5 to 10 carbon atoms and having a substituent", or "linear or branched alkenyl group having 2 to 6 carbon atoms and having a substituent" as represented by R₁ to R₆ in the general formulas (2-1) to (2-3) and (4-1).

Concrete examples of the "aryloxy group" in the "substituted or unsubstituted aryloxy group" as represented by R₁₂ in general formulas (5-3) to (5-6) may include a phenyloxy group, a biphenylyloxy group, a terphenylyloxy group, a naphthyloxy group, an anthracenyloxy group, a phenanthrenyloxy group, a fluorenyloxy group, an indenyloxy group, a pyrenyloxy group, a perylenyloxy group, etc. The above may have a substituent, and examples of the substituent may include the aforementioned examples given for the "substituent" in the "linear or branched alkyl group having 1 to 6 carbon atoms and having a substituent", "cycloalkyl group having 5 to 10 carbon atoms and having a substituent", or "linear or branched alkenyl group having 2 to 6 carbon atoms and having a substituent" as represented by R₁ to R₆ in the general formulas (2-1) to (2-3) and (4-1).

Concrete examples of the "arylthioxy group" in the "substituted or unsubstituted arylthioxy group" as represented by R₁₂ in general formulas (5-3) to (5-6) may include a phenylthioxy group, a biphenylylthioxy group, a terphenylylthioxy group, a naphthylthioxy group, an anthracenylthioxy group, a phenanthrenylthioxy group, a fluorenylthioxy group, an indenylthioxy group, a pyrenylthioxy group, a perylenylthioxy group, etc. The above may have a substituent, and examples of the substituent may include the aforementioned examples given for the "substituent" in the "linear or branched alkyl group having 1 to 6 carbon atoms and having a substituent", "cycloalkyl group having 5 to 10 carbon atoms and having a substituent", or "linear or branched alkenyl group having 2 to 6 carbon atoms and having a substituent" as represented by R₁ to R₆ in the general formulas (2-1) to (2-3) and (4-1).

Concrete examples of the "arylamine group" in the "substituted or unsubstituted arylamine group" as represented by R₁₂ in general formulas (5-3) to (5-6) may include a phenylamine group, a biphenylylamine group, a terphenylylamine group, a naphthylamine group, an anthracenylamine group, a phenanthrenylamine group, a fluorenylamine group, an indenylamine group, a pyrenylamine group, a perylenylamine group, a diphenylamine group, a dibiphenylamine group, a diterphenylamine group, a dinaphthylamine group, a dianthracenylamine group, a difluorenylamine group, a diindenylamine group, etc. The above may have a substituent, and examples of the substituent may include the aforementioned examples given for the "substituent" in the "linear or branched alkyl group having 1 to 6 carbon atoms and having a substituent", "cycloalkyl group having 5 to 10 carbon atoms and having a substituent", or "linear or branched alkenyl group having 2 to 6 carbon atoms and having a substituent" as represented by R₁ to R₆ in the general formulas (2-1) to (2-3) and (4-1).

Concrete examples of the "arylsilyl group" in the "substituted or unsubstituted arylsilyl group" as represented by R₁₂ in general formulas (5-3) to (5-6) may include a triphenylsilyl group, a trinaphthylsilyl group, a terphenylylsilyl group, etc. The above may have a substituent, and examples of the substituent may include the aforementioned examples given for the "substituent" in the "linear or branched alkyl group having 1 to 6 carbon atoms and having a substituent", "cycloalkyl group having 5 to 10 carbon atoms and having a substituent", or "linear or branched alkenyl group having 2 to 6 carbon atoms and having a substituent" as represented by R₁ to R₆ in the general formulas (2-1) to (2-3) and (4-1).

The triarylamine compound represented by the general formula (1) has such properties as (1) excellent hole injection properties, (2) high hole mobility, (3) excellent electron blockability, (4) stability in a thin-film state, and (5) excellent heat resistance. Hence, the triarylamine compound can suitably be used as a constituent material of a hole transport layer of an organic EL device according to the present invention.

The organic EL device according to the present invention, which uses the triarylamine compound represented by the general formula (1) as a constituent material of a hole transport layer, has high efficiency, low driving voltage, and long lifetime, because it uses a triarylamine compound that has higher hole mobility than conventional hole-transporting materials, excellent electron blockability, excellent amorphous properties, and stability in a thin-film state.

In the present invention, the hole transport layer is made into a two-layer structure including a first hole transport layer and a second hole transport layer, and the second hole transport layer located on the side adjacent to the light-emitting layer is formed by containing the triarylamine compound represented by the general formula (1). In this way, it is possible to make the most of the electron blockability of the triarylamine compound, and thus, an organic EL device having even higher efficiency and longer lifetime can be achieved.

Further, in the present invention, the absolute value of the difference between the HOMO level of the second hole transport layer and the HOMO level of the first hole transport layer is 0.15 eV or less. In this way, excellent hole injection properties and hole transportability can be achieved, and thus, an organic EL device having even higher efficiency, lower driving voltage, and longer lifetime can be achieved.

### Brief Description of Drawings

[Fig. 1] Fig. 1 is a diagram illustrating structural formulas of Compounds 1-1 to 1-12 as examples of triarylamine compounds represented by general formula (1).
[Fig. 2] Fig. 2 is a diagram illustrating structural formulas of Compounds 1-13 to 1-24 as examples of triarylamine compounds represented by general formula (1).
[Fig. 3] Fig. 3 is a diagram illustrating structural formulas of Compounds 1-25 to 1-36 as examples of triarylamine compounds represented by general formula (1).
[Fig. 4] Fig. 4 is a diagram illustrating structural formulas of Compounds 1-37 to 1-48 as examples of triarylamine compounds represented by general formula (1).
[Fig. 5] Fig. 5 is a diagram illustrating structural formulas of Compounds 1-49 to 1-60 as examples of triarylamine compounds represented by general formula (1).
[Fig. 6] Fig. 6 is a diagram illustrating structural formulas of Compounds 1-61 to 1-72 as examples of triarylamine compounds represented by general formula (1).
[Fig. 7] Fig. 7 is a diagram illustrating structural formulas of Compounds 1-73 to 1-84 as examples of triarylamine compounds represented by general formula (1).
[Fig. 8] Fig. 8 is a diagram illustrating structural formulas of Compounds 1-85 to 1-96 as examples of triarylamine compounds represented by general formula (1).
[Fig. 9] Fig. 9 is a diagram illustrating structural formulas of Compounds 1-97 to 1-105 as examples of triarylamine compounds represented by general formula (1).
[Fig. 10] Fig. 10 is a diagram illustrating structural formulas of Compounds 3-1 to 3-12 as examples of triarylamine compounds represented by general formula (3).
[Fig. 11] Fig. 11 is a diagram illustrating structural formulas of Compounds 3-13 to 3-24 as examples of triarylamine compounds represented by general formula (3).
[Fig. 12] Fig. 12 is a diagram illustrating structural formulas of Compounds 3-25 to 3-36 as examples of triarylamine compounds represented by general formula (3).
[Fig. 13] Fig. 13 is a diagram illustrating structural formulas of Compounds 3-37 to 3-48 as examples of triarylamine compounds represented by general formula (3).
[Fig. 14] Fig. 14 is a diagram illustrating structural formulas of Compounds 3-49 to 3-60 as examples of triarylamine compounds represented by general formula (3).
[Fig. 15] Fig. 15 is a diagram illustrating structural formulas of Compounds 3-61 to 3-72 as examples of triarylamine compounds represented by general formula (3).
[Fig. 16] Fig. 16 is a diagram illustrating structural formulas of Compounds 3-73 to 3-84 as examples of triarylamine compounds represented by general formula (3).
[Fig. 17] Fig. 17 is a diagram illustrating structural formulas of Compounds 3-85 to 3-96 as examples of triarylamine compounds represented by general formula (3).
[Fig. 18] Fig. 18 is a diagram illustrating structural formulas of Compounds 3-97 to 3-108 as examples of triarylamine compounds represented by general formula (3).
[Fig. 19] Fig. 19 is a diagram illustrating structural formulas of Compounds 3-109 to 3-120 as examples of triarylamine compounds represented by general formula (3).
[Fig. 20] Fig. 20 is a diagram illustrating structural formulas of Compounds 3-121 to 3-132 as examples of triarylamine compounds represented by general formula (3).
[Fig. 21] Fig. 21 is a diagram illustrating structural formulas of Compounds 3-133 to 3-144 as examples of triarylamine compounds represented by general formula (3).
[Fig. 22] Fig. 22 is a diagram illustrating structural formulas of Compounds 3-145 to 3-156 as examples of triarylamine compounds represented by general formula (3).
[Fig. 23] Fig. 23 is a diagram illustrating structural formulas of Compounds 3-157 to 3-168 as examples of triarylamine compounds represented by general formula (3).
[Fig. 24] Fig. 24 is a diagram illustrating structural formulas of Compounds 3-169 to 3-180 as examples of triarylamine compounds represented by general formula (3).
[Fig. 25] Fig. 25 is a diagram illustrating structural formulas of Compounds 3-181 to 3-195 as examples of triarylamine compounds represented by general formula (3).
[Fig. 26] Fig. 26 is a diagram illustrating structural formulas of Compounds 3-196 to 3-207 as examples of triarylamine compounds represented by general formula (3).
[Fig. 27] Fig. 27 is a diagram illustrating structural formulas of Compounds 3-208 to 3-219 as examples of triarylamine compounds represented by general formula (3).
[Fig. 28] Fig. 28 is a diagram illustrating structural formulas of Compounds 3-220 to 3-231 as examples of triarylamine compounds represented by general formula (3).
[Fig. 29] Fig. 29 is a diagram illustrating structural formulas of Compounds 3-232 to 3-243 as examples of triarylamine compounds represented by general formula (3).
[Fig. 30] Fig. 30 is a diagram illustrating structural formulas of Compounds 3-244 to 3-255 as examples of triarylamine compounds represented by general formula (3).
[Fig. 31] Fig. 31 is a diagram illustrating structural formulas of Compounds 3-256 to 3-269 as examples of triarylamine compounds represented by general formula (3).
[Fig. 32] Fig. 32 is a diagram illustrating structural formulas of Compounds 3-270 to 3-282 as examples of triarylamine compounds represented by general formula (3).
[Fig. 33] Fig. 33 is a diagram illustrating structural formulas of Compounds 3-283 to 3-297 as examples of triarylamine compounds represented by general formula (3).
[Fig. 34] Fig. 34 is a diagram illustrating structural formulas of Compounds 3-298 to 3-311 as examples of triarylamine compounds represented by general formula (3).
[Fig. 35] Fig. 35 is a diagram illustrating structural formulas of Compounds 3-312 to 3-326 as examples of triarylamine compounds represented by general formula (3).
[Fig. 36] Fig. 36 is a diagram illustrating structural formulas of Compounds 3-327 to 3-338 as examples of triarylamine compounds represented by general formula (3).
[Fig. 37] Fig. 37 is a diagram illustrating structural formulas of Compounds 3-339 to 3-353 as examples of triarylamine compounds represented by general formula (3).
[Fig. 38] Fig. 38 is a diagram illustrating structural formulas of Compounds 3-354 to 3-368 as examples of triarylamine compounds represented by general formula (3).
[Fig. 39] Fig. 39 is a diagram illustrating structural formulas of Compounds 3-369 to 3-384 as examples of triarylamine compounds represented by general formula (3).
[Fig. 40] Fig. 40 is a diagram illustrating structural formulas of Compounds 3-385 to 3-392 as examples of triarylamine compounds represented by general formula (3).
[Fig. 41] Fig. 41 is a diagram illustrating structures of Compounds 5-1-1 to 5-1-15 as examples of compounds represented by general formula (5-1).
[Fig. 42] Fig. 42 is a diagram illustrating structural formulas of Compounds 5-1-16 to 5-1-26 as examples of compounds represented by general formula (5-1).
[Fig. 43] Fig. 43 is a diagram illustrating structural formulas of Compounds 5-2-1 to 5-2-12 as examples of compounds represented by general formula (5-2).
[Fig. 44] Fig. 44 is a diagram illustrating an example of a configuration of an organic EL device according to the present invention.

### Description of Embodiments

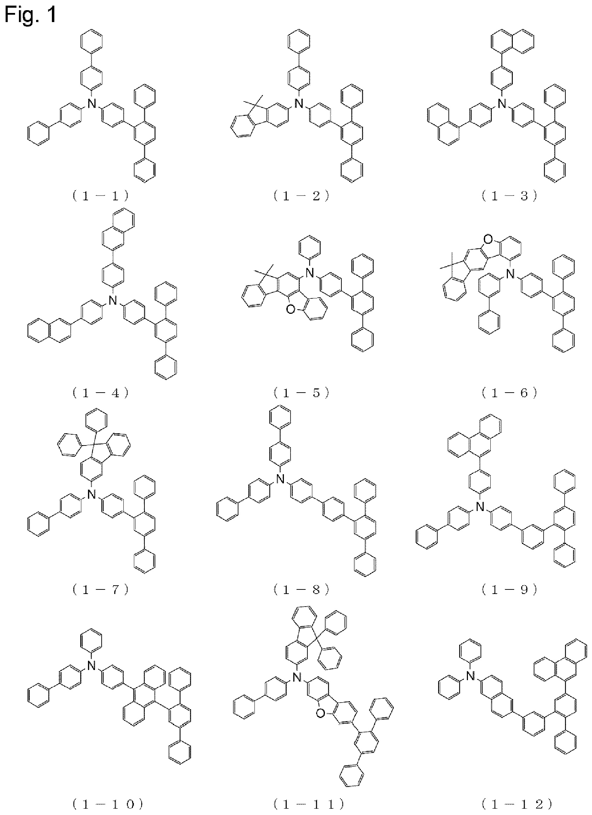

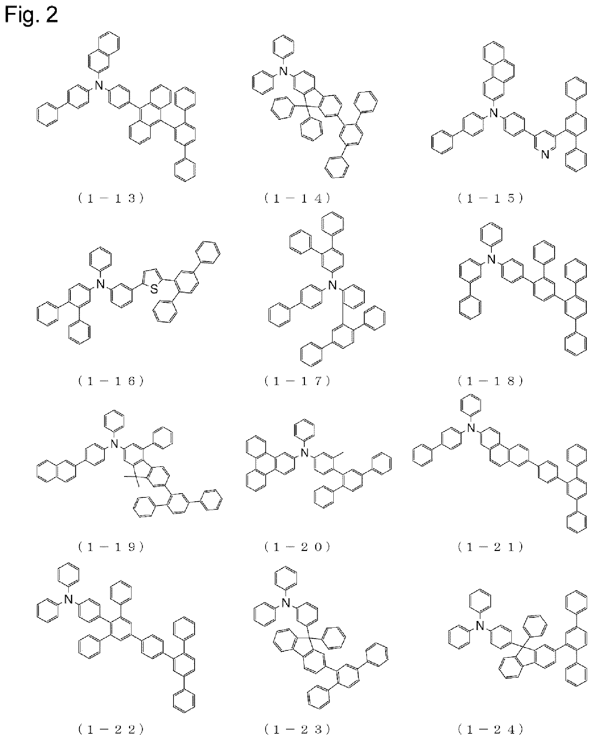

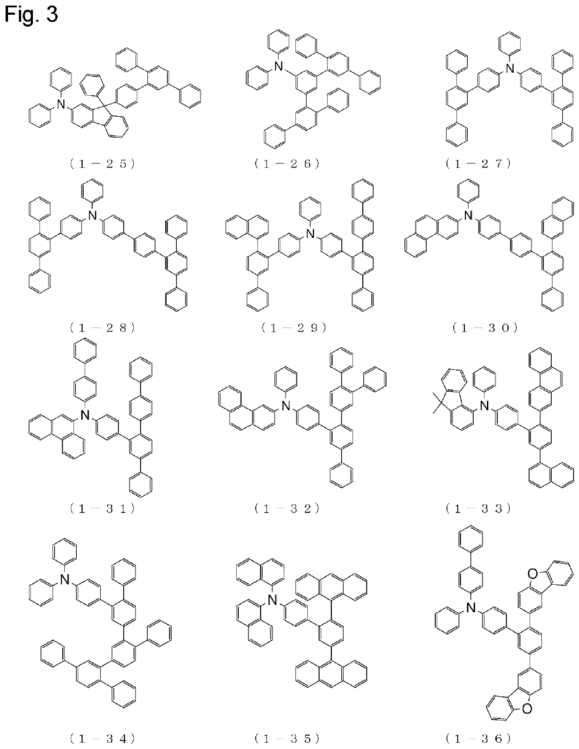

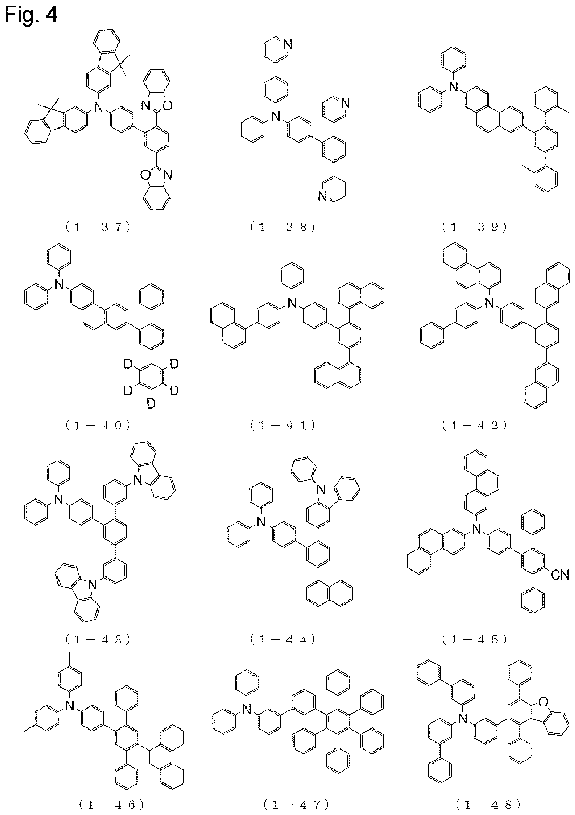

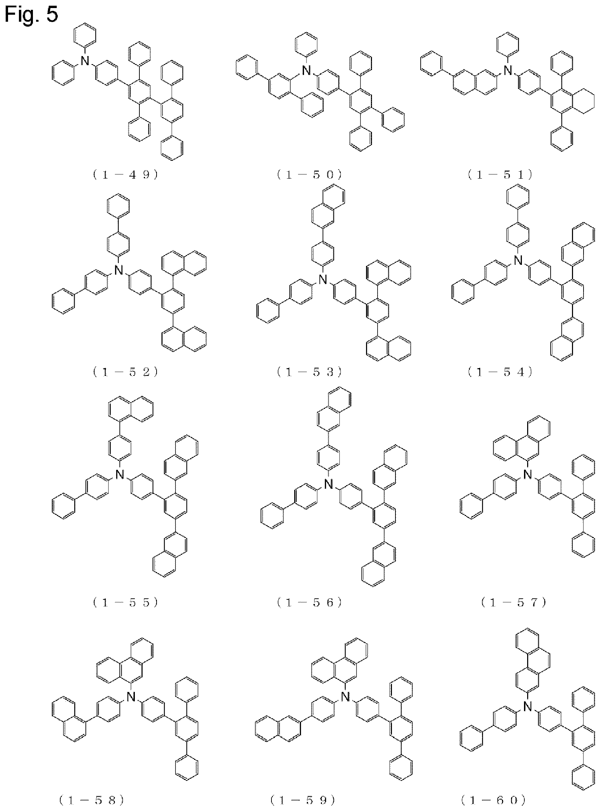

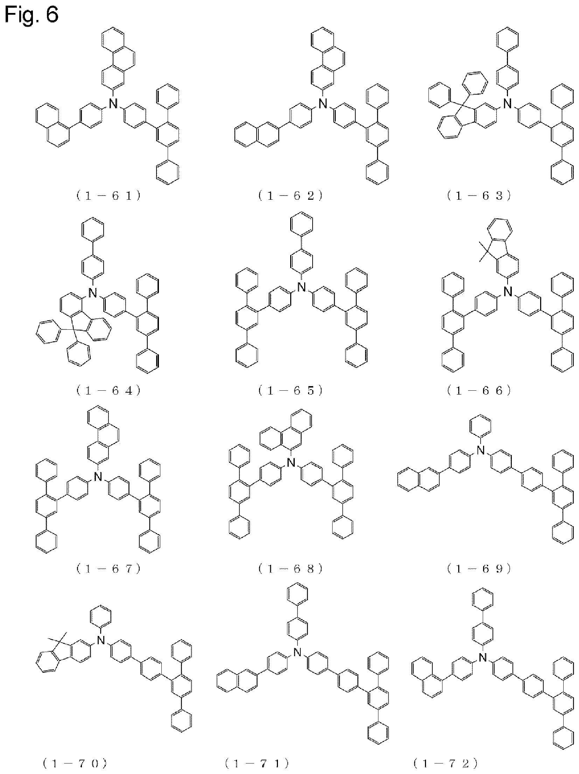

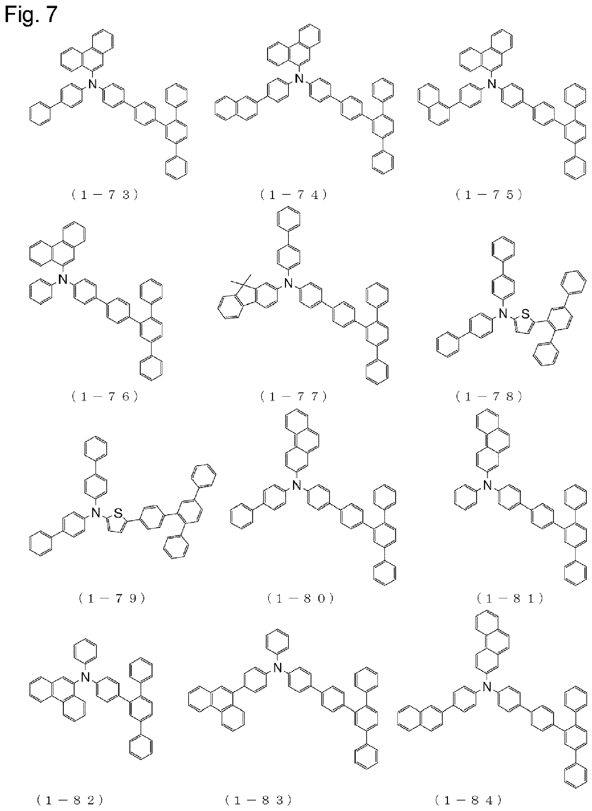

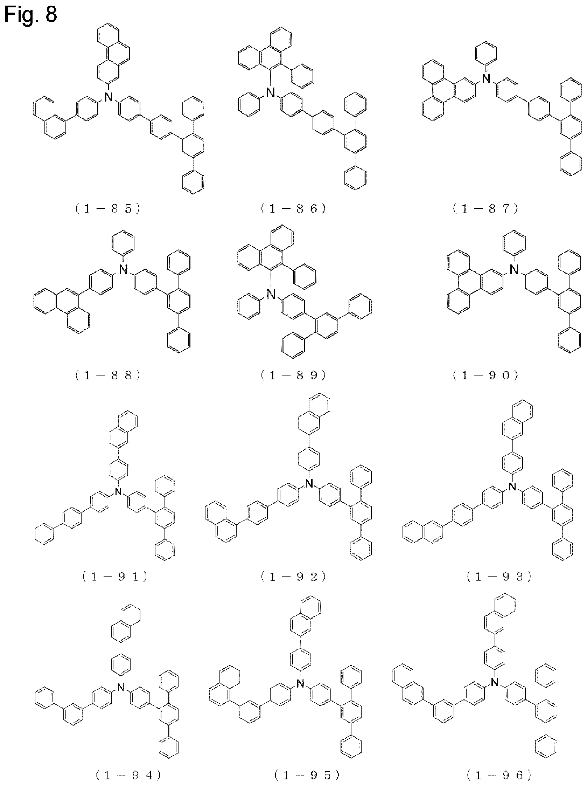

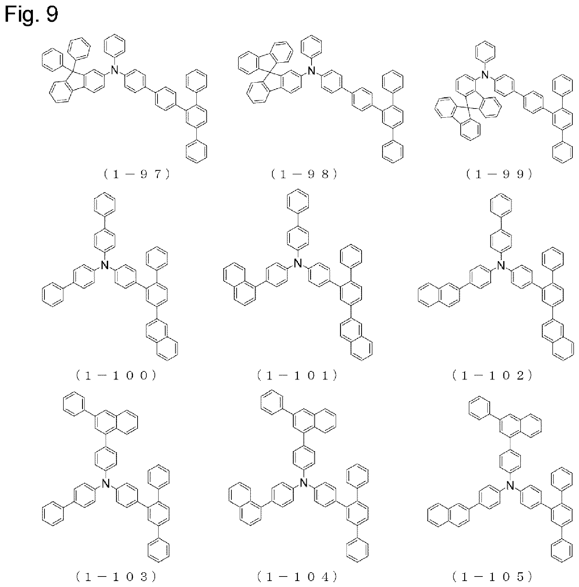

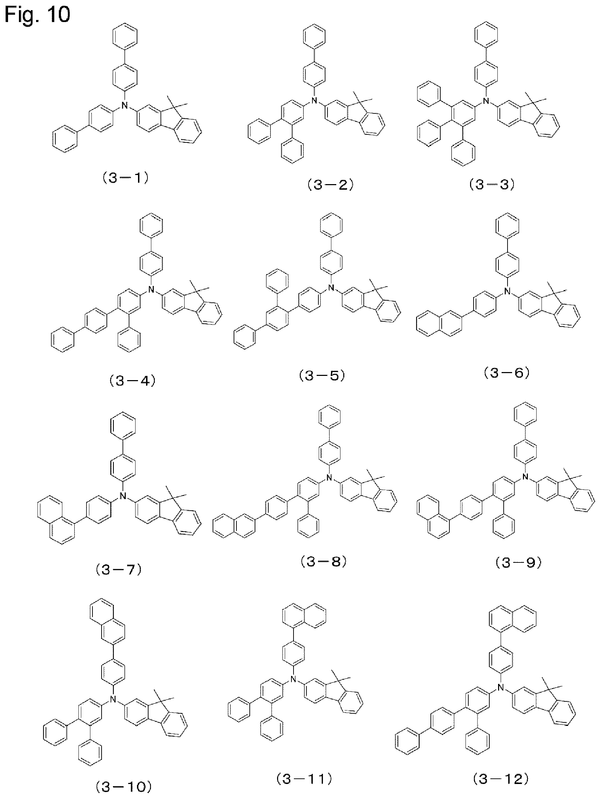

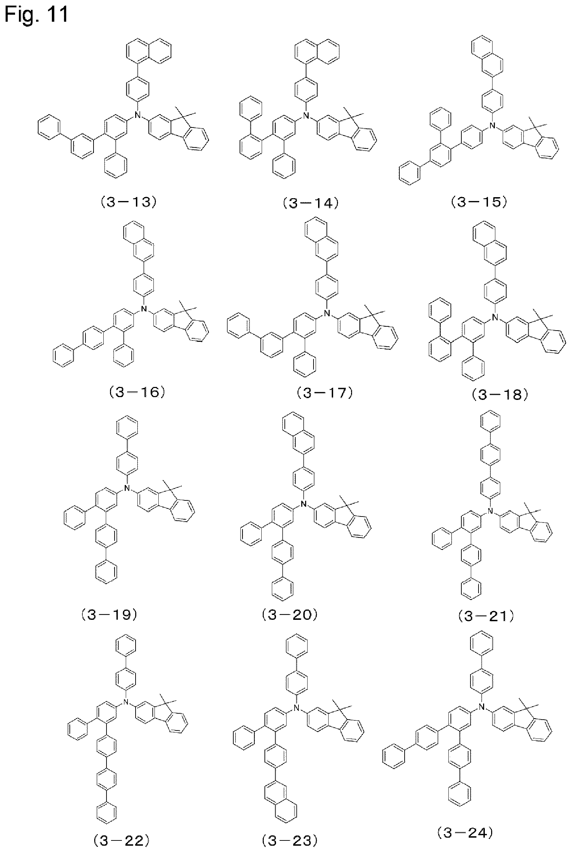

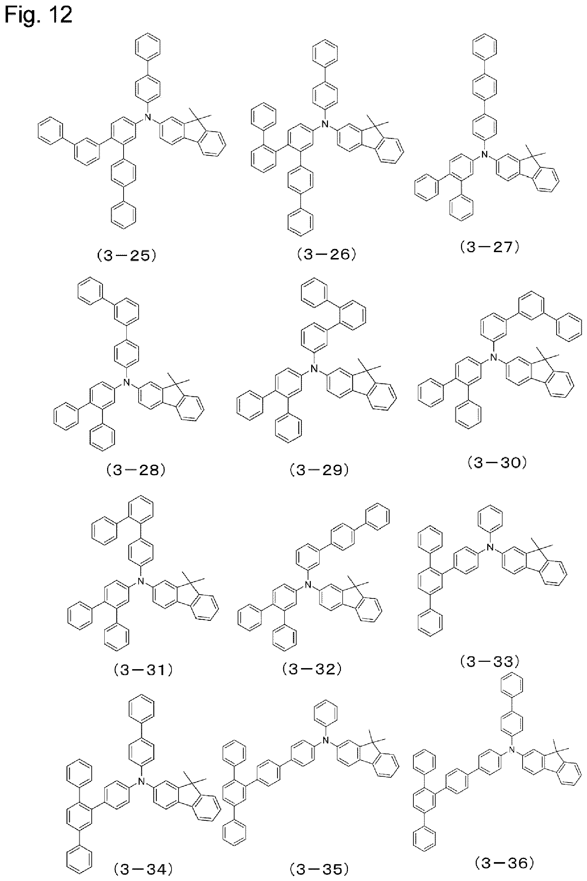

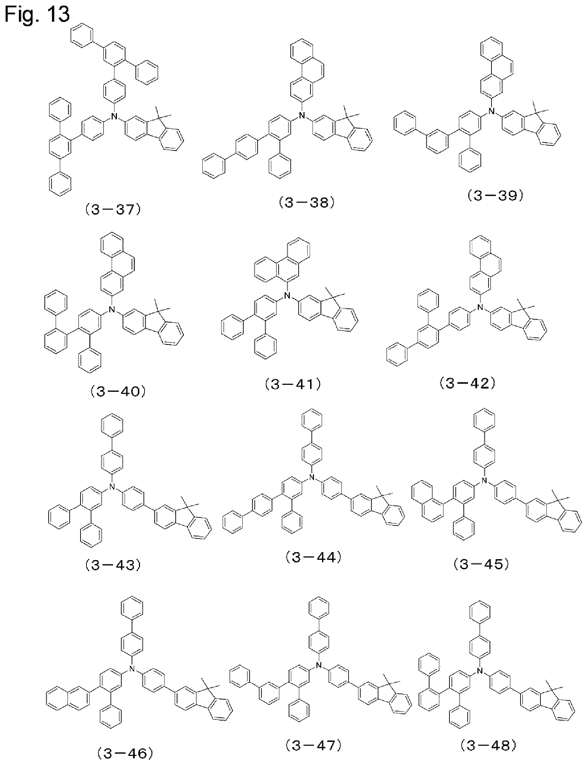

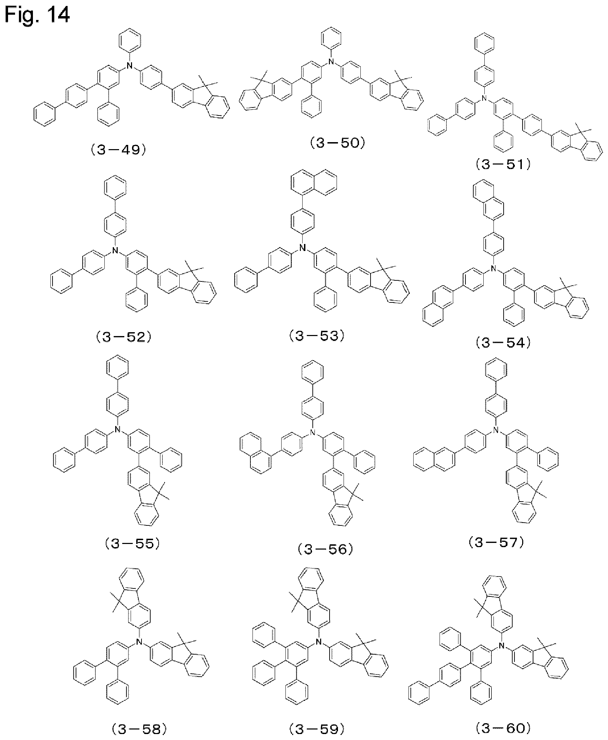

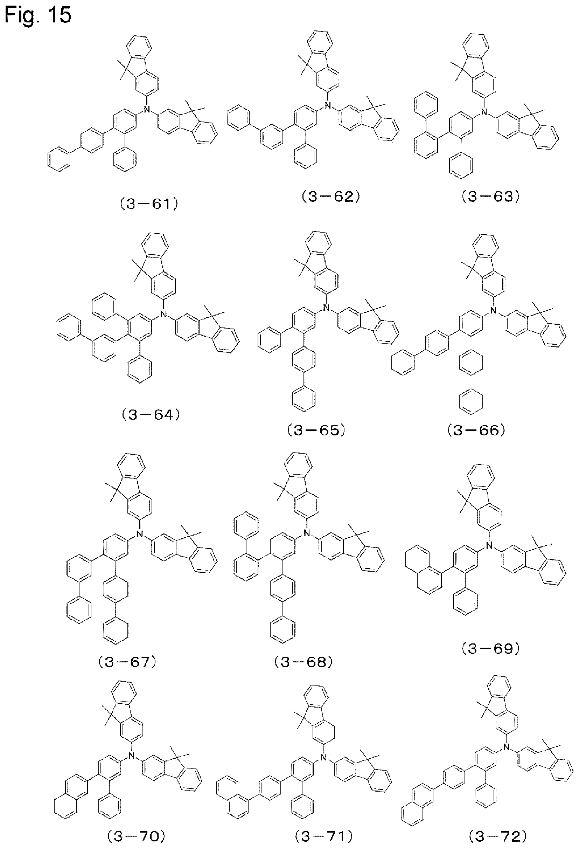

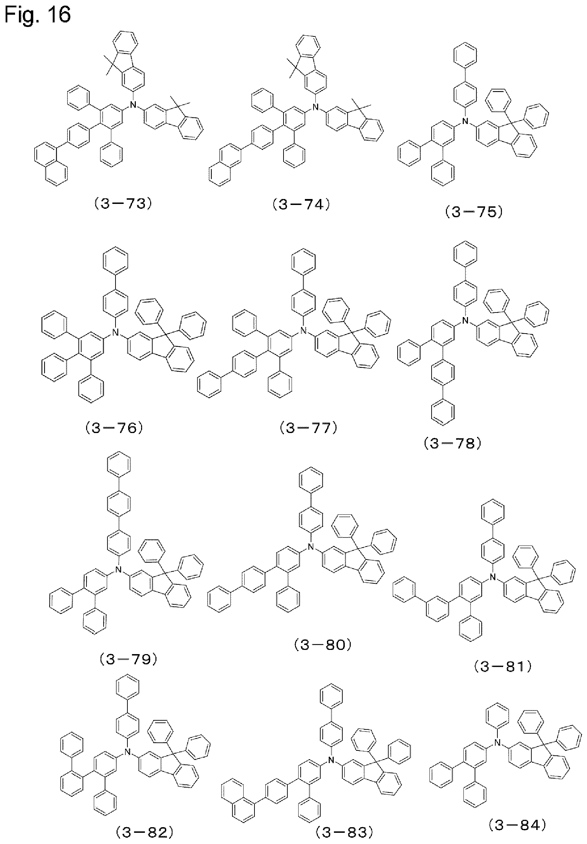

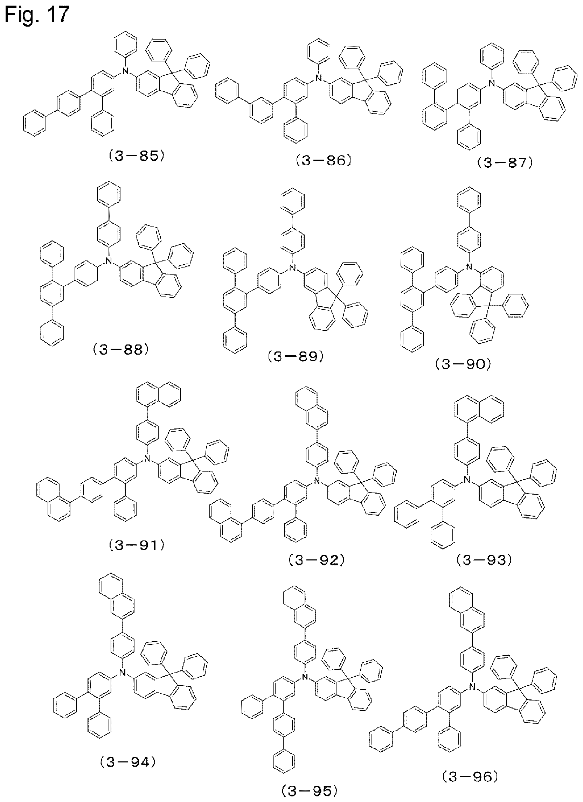

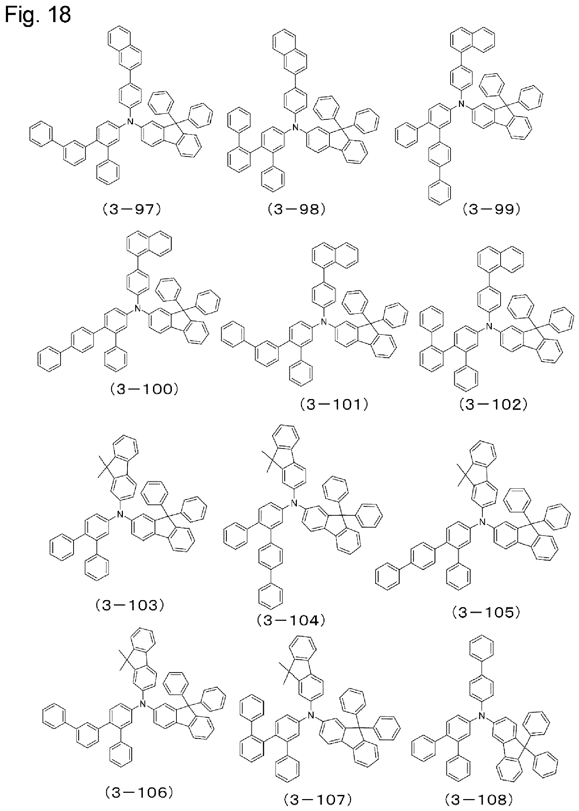

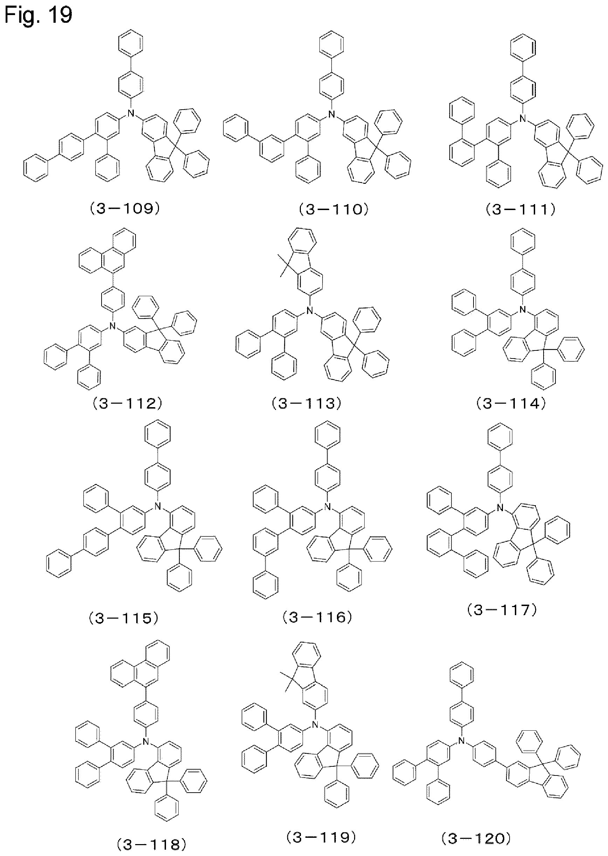

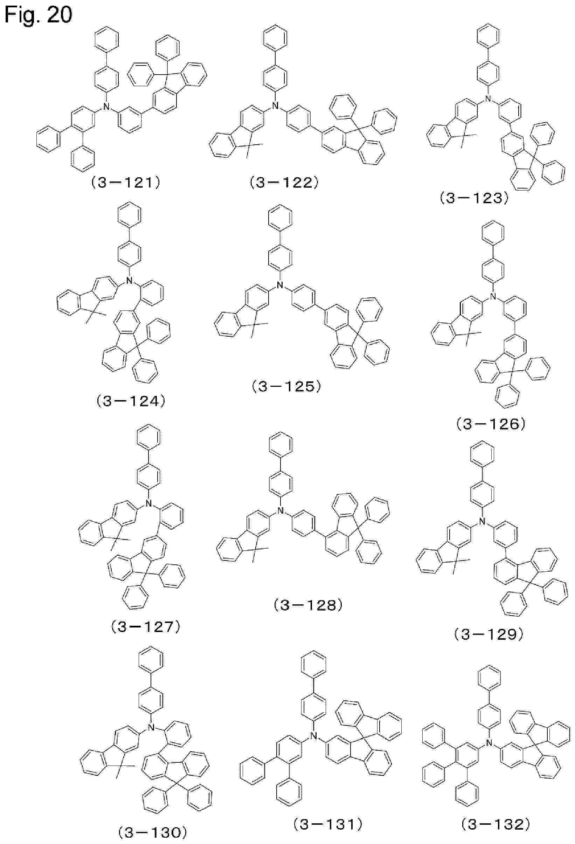

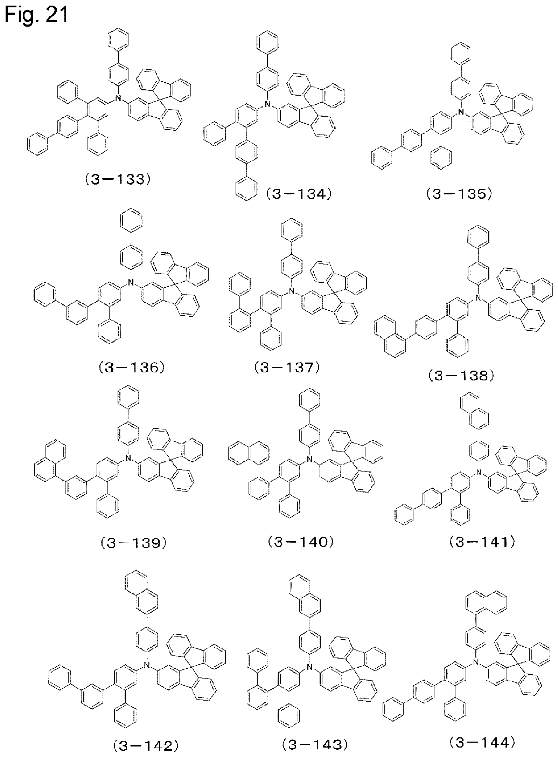

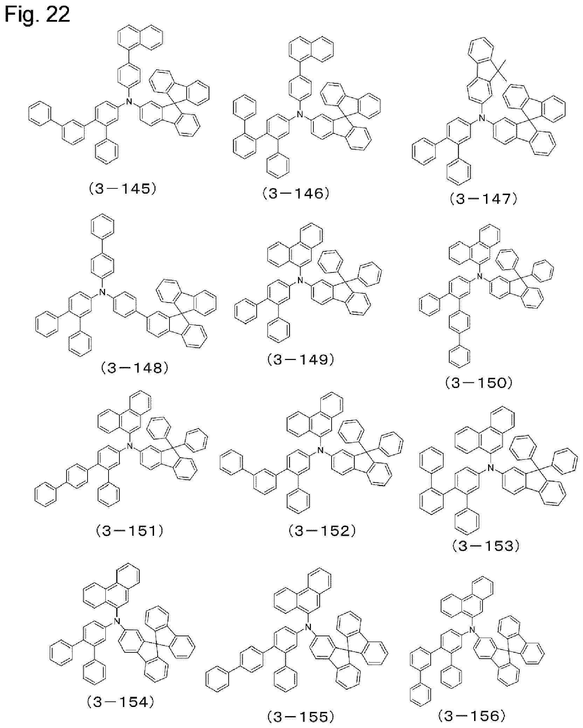

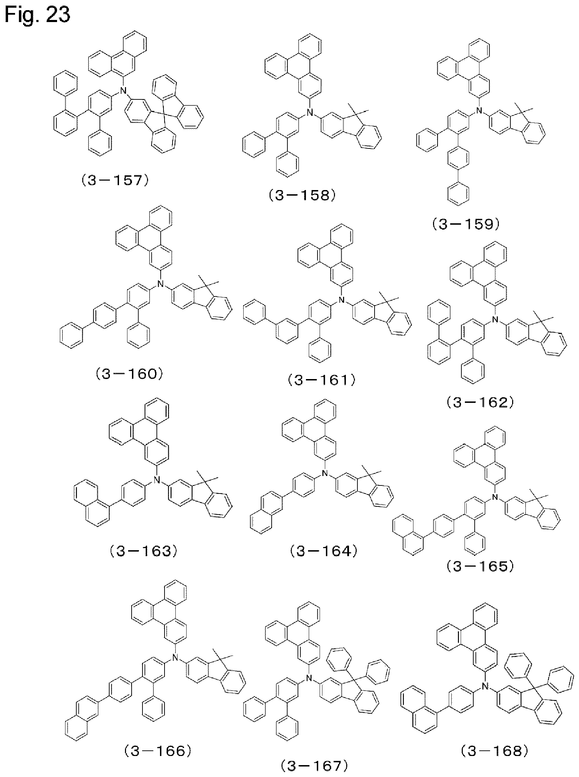

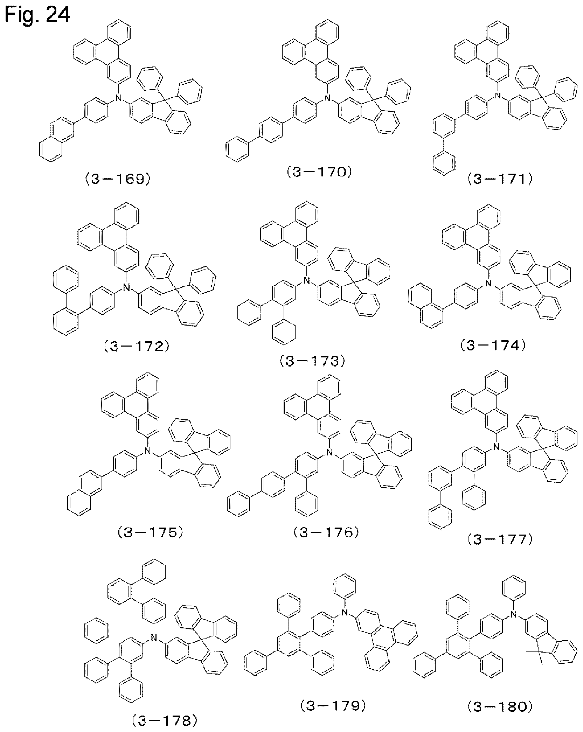

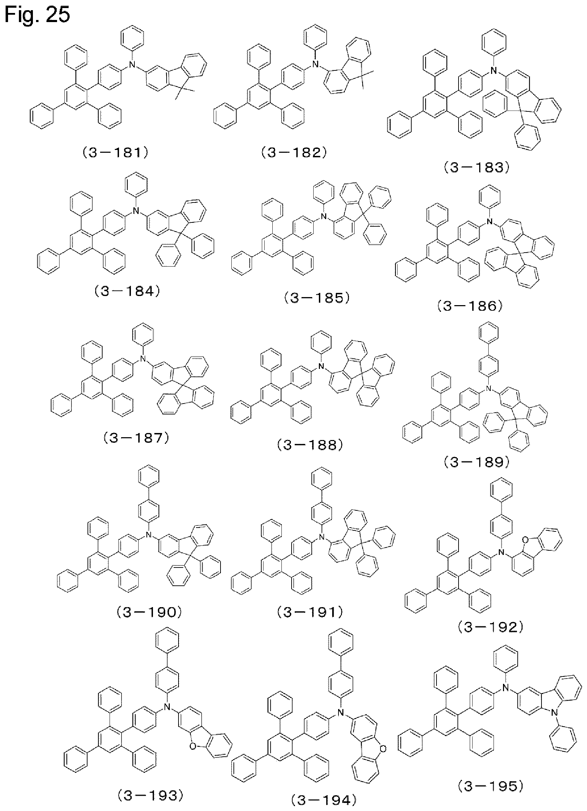

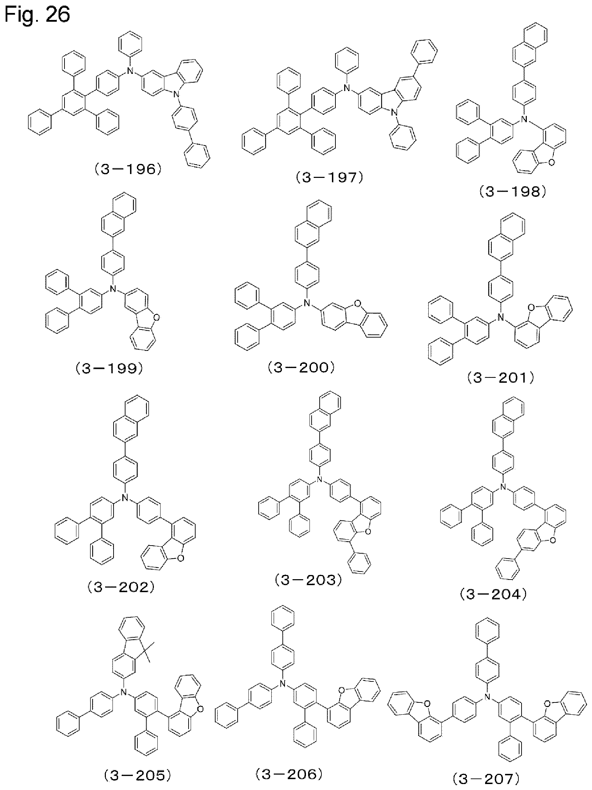

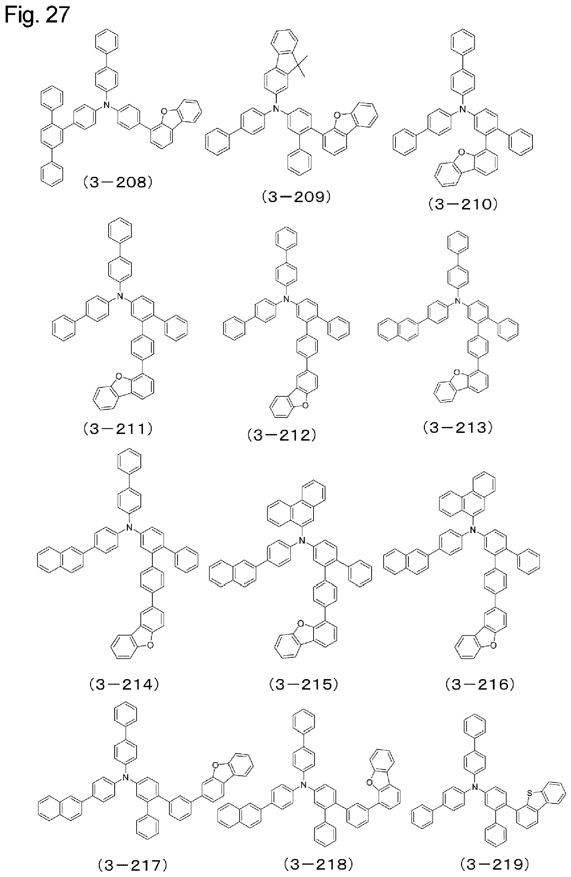

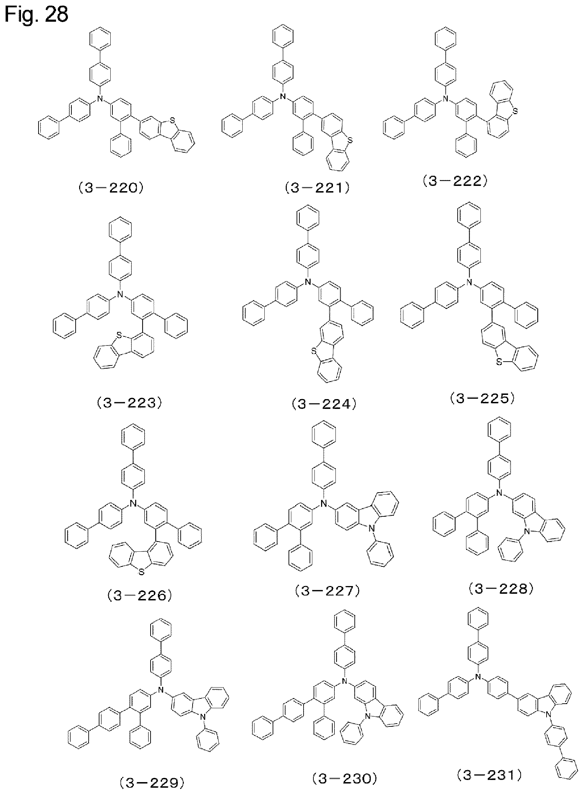

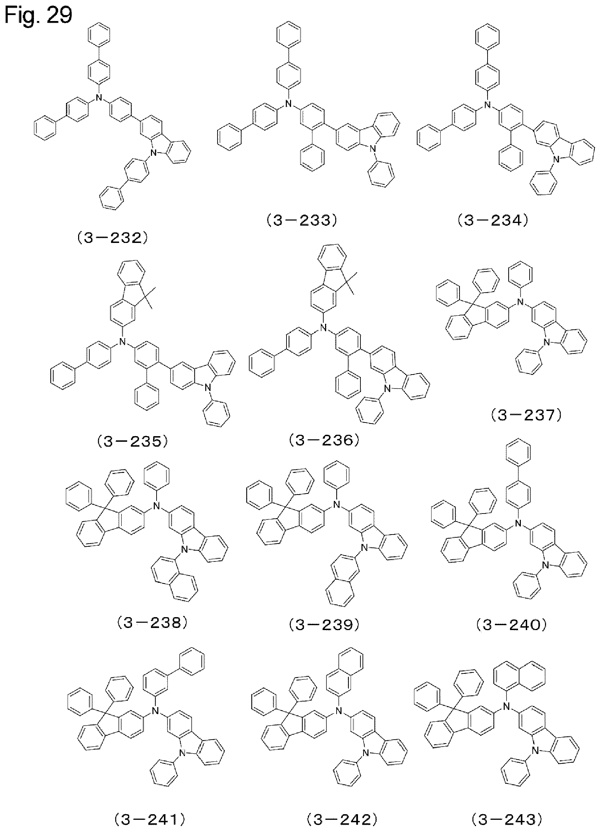

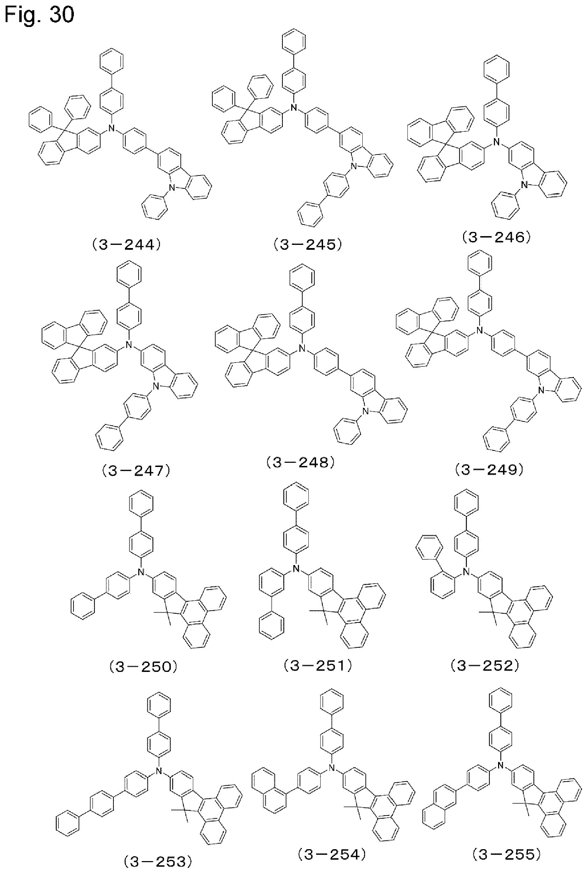

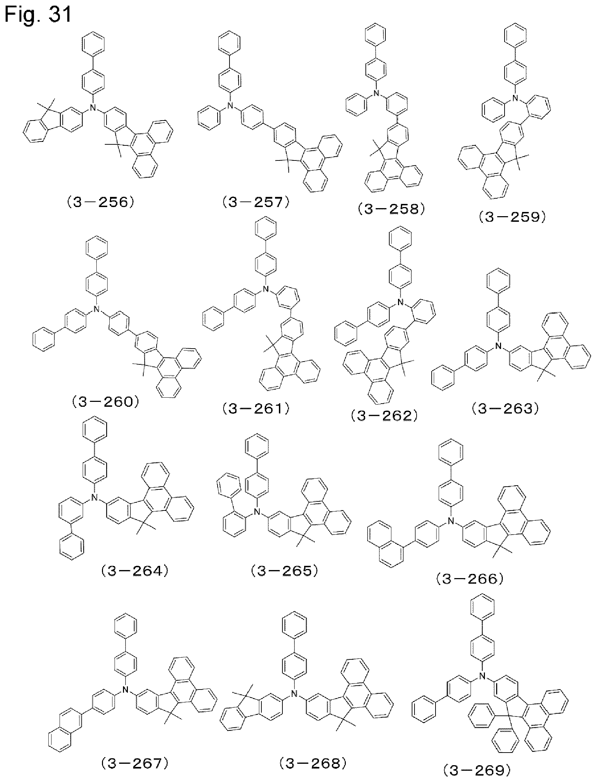

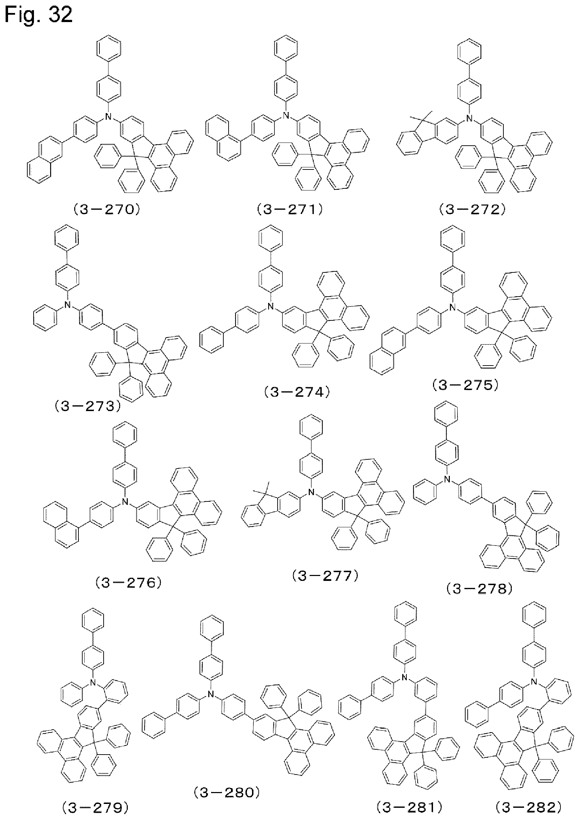

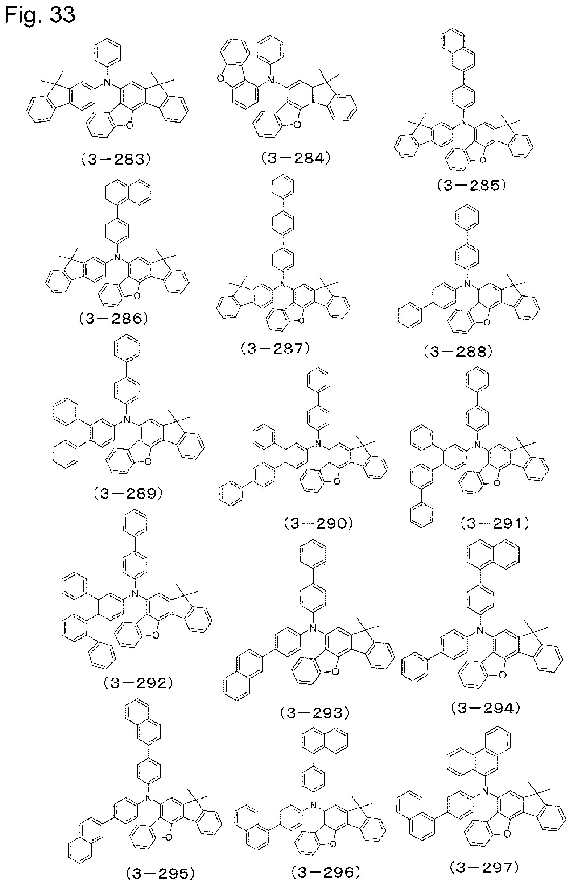

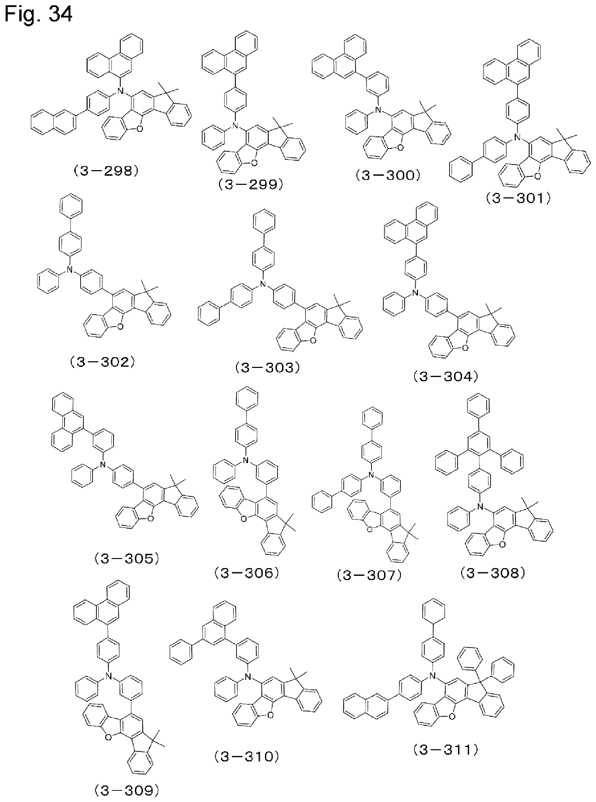

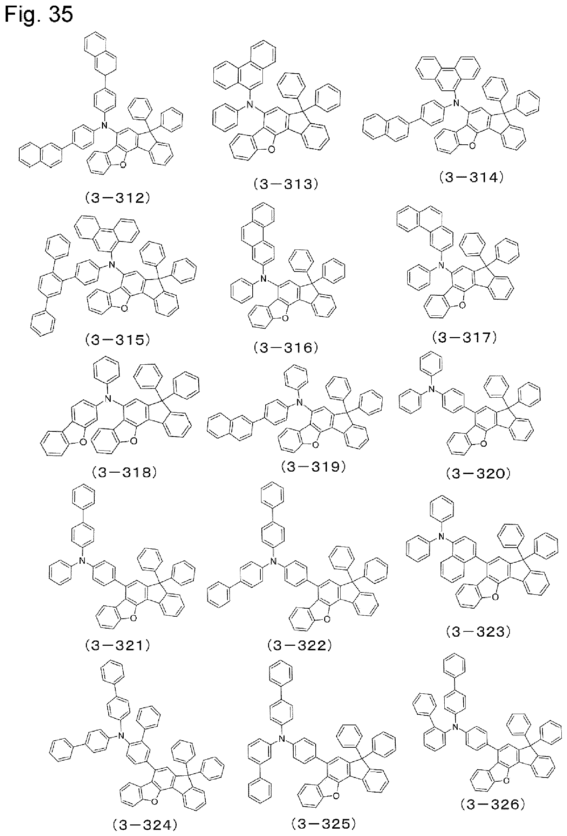

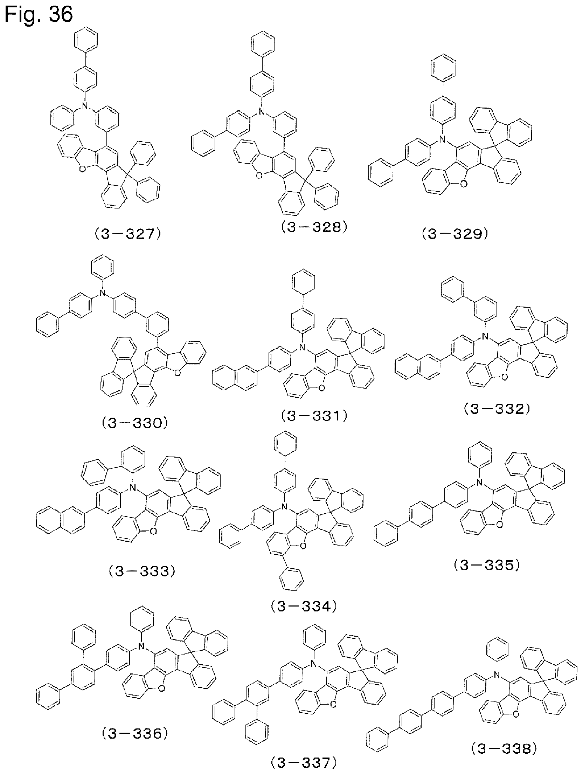

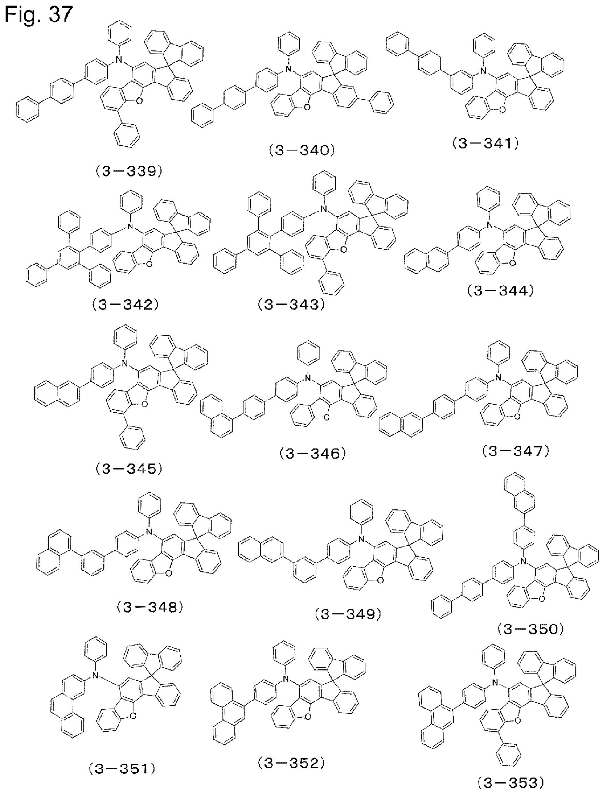

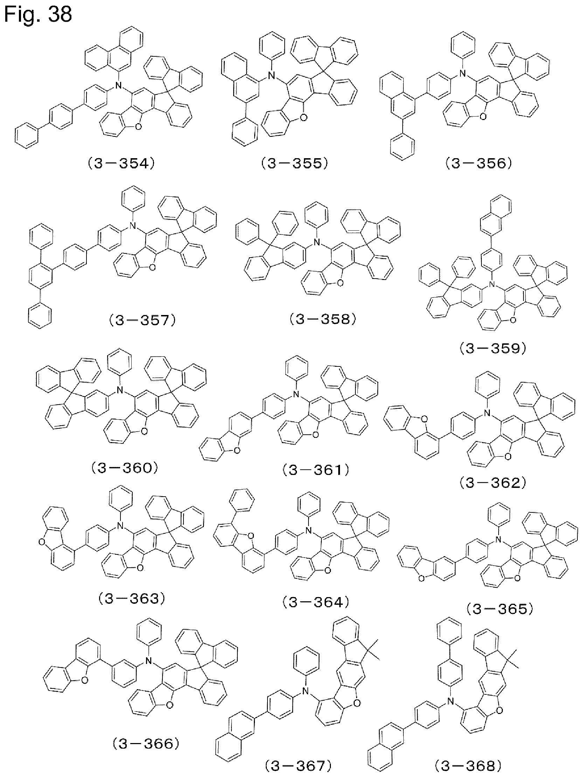

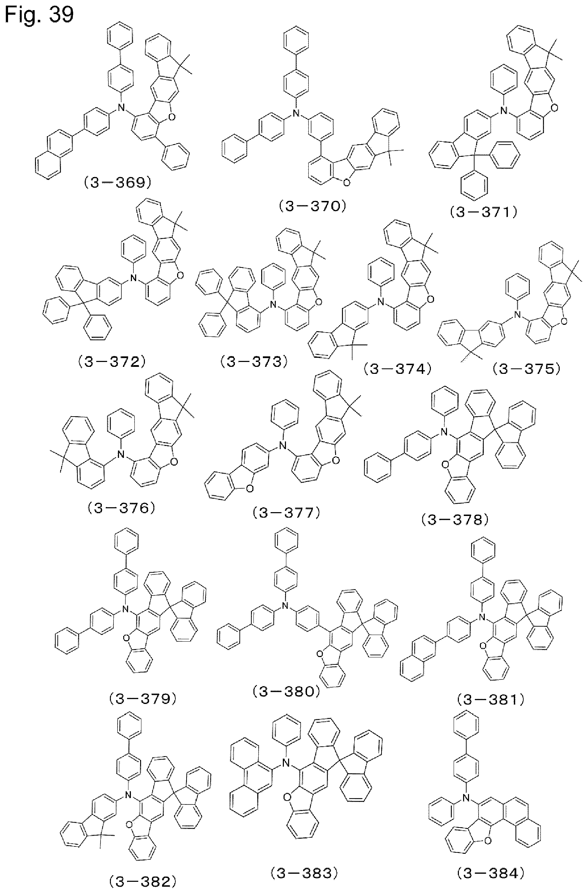

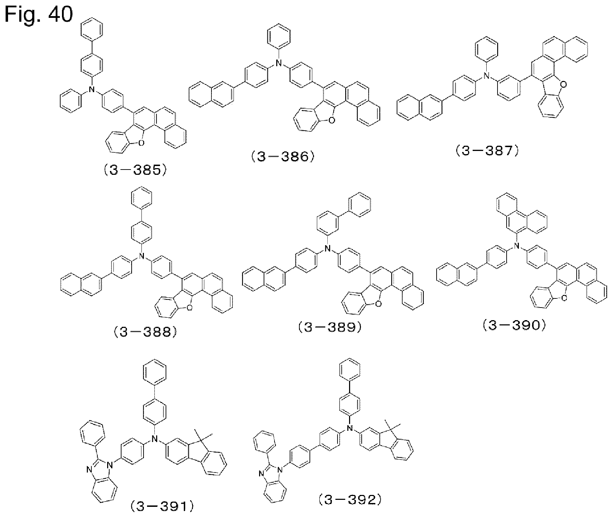

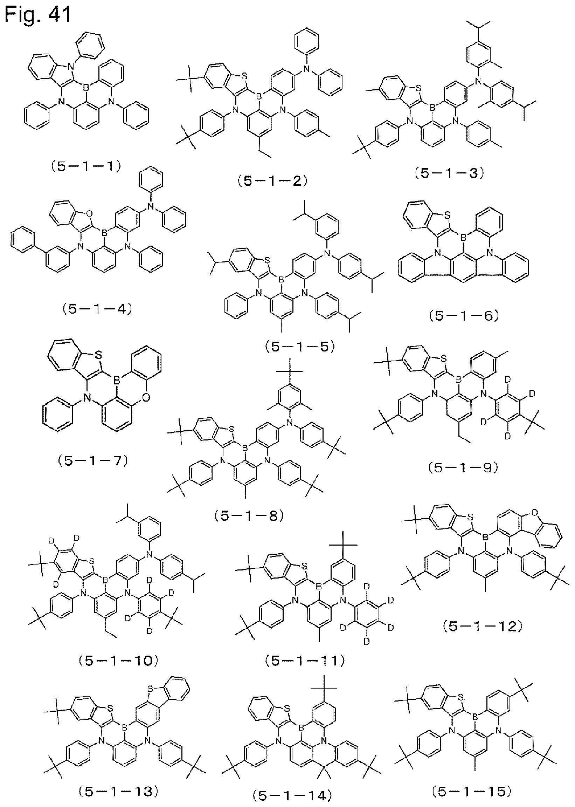

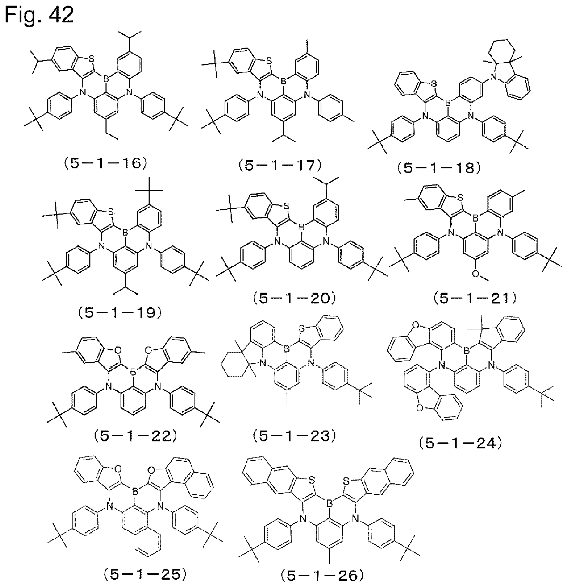

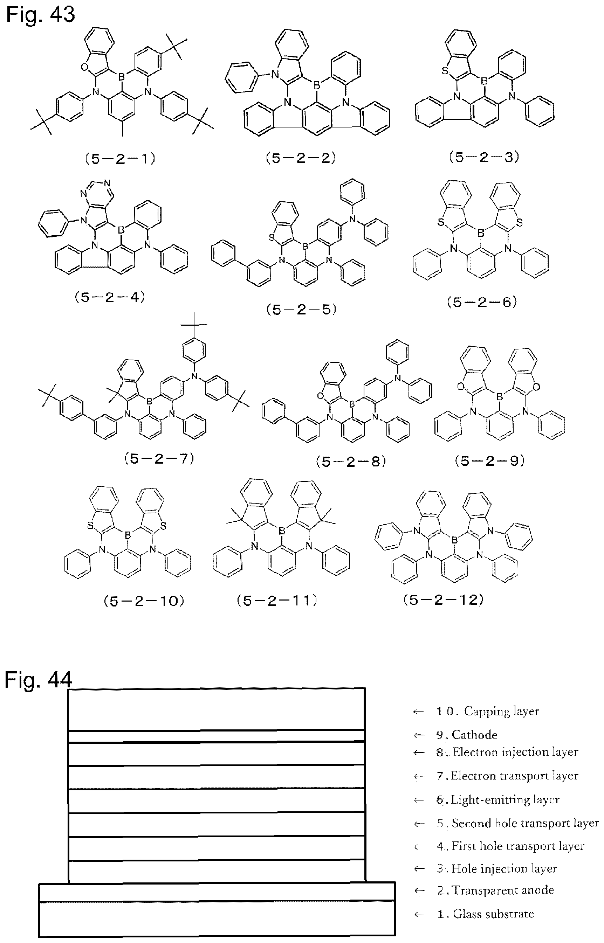

Figs. 1 to 9 illustrate concrete examples of preferred compounds among triarylamine compounds represented by the general formula (1), Figs. 10 to 40 illustrate concrete examples of preferred compounds among triarylamine compounds represented by the general formula (3), Figs. 41 and 42 illustrate concrete examples of preferred compounds among compounds represented by the general formula (5-1), and Fig. 43 illustrates concrete examples of preferred compounds among compounds represented by the general formula (5-2), all of which may suitably be used for an organic EL device of the present invention. Note, however, that the compounds are not limited to the illustrated compounds.

The triarylamine compound represented by general formula (1) can be purified by methods, such as column chromatography purification, adsorption purification with silica gel, activated carbon, activated clay, etc., recrystallization or crystallization using a solvent, sublimation purification, or the like. Compound identification can be achieved by NMR analysis. It is preferable to measure such physical property values as the melting point, glass transition point (Tg), work function, or the like. The melting point serves as an index of vapor deposition characteristics. The glass transition point (Tg) serves as an index of stability in a thin-film state. The work function serves as an index of hole transportability and/or hole blockability. It is preferable that compounds to be used in the organic EL device of the present invention are purified by methods, such as column chromatography purification, adsorption purification with silica gel, activated carbon, activated clay, etc., recrystallization or crystallization using a solvent, sublimation purification, etc., and then ultimately purified by sublimation purification.

The melting point and glass transition point (Tg) can be measured with a high-sensitivity differential scanning calorimeter (DSC3100SA from Bruker AXS) using a powder.

The HOMO level of each layer can be found with an ionization potential measurement device (PYS-202 from Sumitomo Heavy Industries, Ltd.) by preparing a 100-nm thin film on an ITO substrate.

A structure of the organic EL device of the present invention may, for example, sequentially include, on a substrate, an anode, a first hole transport layer, a second hole transport layer, a light-emitting layer, an electron transport layer, and a cathode. In other examples, a hole injection layer may be provided between the anode and the first hole transport layer, or a hole blocking layer may be provided between the light-emitting layer and the electron transport layer, or an electron injection layer may be provided between the electron transport layer and the cathode. In such multilayer structures, for example, a single layer may have functions of the hole injection layer and the first hole transport layer, or functions of the electron injection layer and the electron transport layer. Further, it is possible to stack two or more organic layers having the same function; for example, the structure may include: two stacked first hole transport layers; two stacked second hole transport layers; two stacked light-emitting layers; or two stacked electron transport layers. For the structure of the organic EL device of the present invention, it is preferable that the second hole transport layer is adjacent to the light-emitting layer and also has the function as an electron blocking layer.

For the anode in the organic EL device of the present invention, it is possible to use an electrode material having a large work function, such as ITO or gold. For the hole injection layer in the organic EL device of the present invention, it is possible to use, for example: a starburst-type triphenylamine derivative; a material such as one of various triphenylamine tetramers; a porphyrin compound typified by copper phthalocyanine; an acceptor heterocyclic compound such as hexacyanoazatriphenylene; or a coating-type polymer material.

For the hole-transportable material usable for the first hole transport layer in the organic EL device of the present invention, it is possible to use, for example: a benzidine derivative, such as N,N'-diphenyl-N,N'-di(m-tolyl) benzidine ("TPD"), N,N'-diphenyl-N,N'-di(α-naphthyl) benzidine ("NPD"), N,N,N',N'-tetrabiphenylylbenzidine, etc.; 1,1-bis[4-(di-4-tolylamino)phenyl]cyclohexane ("TAPC"); the triarylamine compounds represented by the general formula (1) or general formula (3); or other compounds such as various triphenylamine derivatives. As for the first hole transport layer of the organic EL device of the present invention, it is preferable to use the triarylamine compound represented by the general formula (3).

For the hole injection layer or the first hole transport layer, it is possible to use: a material ordinarily used for such layers and p-doped with, for example, trisbromophenylamine hexachloroantimonate or a radialene derivative (see, for example, Patent Literature 7); or a polymer compound having, as a partial structure thereof, a benzidine derivative structure such as TPD.

For the second hole transport layer in the organic EL device of the present invention, the triarylamine compound represented by the general formula (1) is to be used. Examples of hole-transportable materials that may be used simultaneously with or by being mixed with the triarylamine compound represented by the general formula (1) may include compounds having an electron blocking action, such as: a carbazole derivative, such as 4,4',4"-tri(N-carbazolyl)triphenylamine ("TCTA"), 9,9-bis[4-(carbazol-9-yl)phenyl] fluorene, 1,3-bis(carbazol-9-yl)benzene ("mCP"), 2,2-bis(4-carbazol-9-ylphenyl)adamantane ("Ad-Cz"), etc.; or a compound containing a triarylamine structure and a triphenylsilyl group typified by 9-[4-(carbazol-9-yl)phenyl]-9-[4-(triphenylsilyl)phenyl]-9H-fluorene, etc.

In the present invention, the absolute value of the difference between the HOMO level of the second hole transport layer and the HOMO level of the first hole transport layer is 0.15 eV or less, more preferably 0.12 eV or less, and even more preferably 0.10 eV or less.

For the light-emitting layer in the organic EL device of the present invention, it is possible to use, for example, a metal complex of a quinolinol derivative, e.g., Alq₃, as well as various other metal complexes, an anthracene derivative, a bisstyrylbenzene derivative, a pyrene derivative, an oxazole derivative, a poly(para-phenylene vinylene) derivative, etc. The light-emitting layer may be constituted by a host material and a dopant material. For the host material, an anthracene derivative may preferably be used, and also, in addition to the aforementioned light-emitting materials, it is possible to use, for example, a heterocyclic compound having an indole ring as a partial structure of a fused ring, a heterocyclic compound having a carbazole ring as a partial structure of a fused ring, a carbazole derivative, a thiazole derivative, a benzimidazole derivative, a polydialkylfluorene derivative, etc. For the dopant material, it is possible to preferably use a pyrene derivative and/or a compound represented by the general formula (5-1) or (5-2). It is also possible to use quinacridone, coumarin, rubrene, perylene, a derivative of the above, a benzopyran derivative, an indenophenanthrene derivative, a rhodamine derivative, an aminostyryl derivative, etc.

It is also possible to use a phosphorescent substance for the light-emitting material. For the phosphorescent substance, it is possible to use a phosphorescent substance such as a metal complex of iridium, platinum, etc. Examples may include green phosphorescent substances such as Ir(ppy)₃ etc., blue phosphorescent substances such as FIrpic, FIr6, etc., and red phosphorescent substances such as Btp₂Ir(acac) etc. As regards host materials, for the hole injecting/transporting host material, it is possible to use, for example, a carbazole derivative such as 4,4'-di(N-carbazolyl)biphenyl ("CBP"), TCTA, mCP, etc. For the electron-transporting host material, it is possible to use, for example, p-bis(triphenylsilyl)benzene ("UGH2"), 2,2',2"-(1,3,5-phenylene)-tris(1-phenyl-1H-benzimidazole) ("TPBI"), etc. With such materials, it is possible to produce high-performance organic EL devices.

To avoid concentration quenching, doping of the host material(s) with a phosphorescent light-emitting material is preferably performed by co-vapor deposition within a range of 1 to 30 wt.% with respect to the entire light-emitting layer.

Further, for the light-emitting material, it is possible to use a material emitting delayed fluorescence, e.g., PIC-TRZ, CC2TA, PXZ-TRZ, a CDCB derivative such as 4CzIPN, etc. (see, for example, Non-Patent Literature 3).

For the hole blocking layer in the organic EL device of the present invention, it is possible to use a compound having a hole blocking action, with examples including phenanthroline derivatives such as bathocuproine ("BCP"), metal complexes of a quinolinol derivative such as bis(2-methyl-8-quinolinato))-4-phenylphenolato aluminum (III) (abbreviated hereinbelow as "BAlq"), various rare-earth complexes, triazole derivatives, triazine derivatives, oxadiazole derivatives, etc.

For the electron transport layer in the organic EL device of the present invention, it is possible to use a metal complex of a quinolinol derivative such as Alq₃, BAlq, etc., one of various metal complexes, a triazole derivative, a triazine derivative, an oxadiazole derivative, a pyridine derivative, a pyrimidine derivative, a benzimidazole derivative, a thiadiazole derivative, an anthracene derivative, a carbodiimide derivative, a quinoxaline derivative, a pyridoindole derivative, a phenanthroline derivative, a silole derivative, etc.

For the electron injection layer in the organic EL device of the present invention, it is possible to use an alkali metal salt such as lithium fluoride, cesium fluoride, etc., an alkaline-earth metal salt such as magnesium fluoride etc., a metal complex of a quinolinol derivative such as quinolinol lithium etc., a metal oxide such as aluminum oxide etc., or a metal such as ytterbium (Yb), samarium (Sm), calcium (Ca), strontium (Sr), cesium (Cs), etc. The electron injection layer may, however, be omitted by suitable selection of the electron transport layer and the cathode.

In the electron injection layer or the electron transport layer, it is possible to use a material ordinarily used for such layers and further n-doped with a metal such as cesium etc.

For the cathode in the organic EL device of the present invention, an electrode material having a low work function, such as aluminum etc., or an alloy having an even lower work function, such as magnesium silver alloy, magnesium indium alloy, aluminum magnesium alloy, etc., may be used as the electrode material.

The aforementioned materials to be used in the respective layers constituting the organic EL device of the present invention may each be formed into a film singly, or may be mixed with other materials and formed into a film which may be used as a single layer. It is possible to form a laminate structure constituted by layers each formed singly by the respective materials, or constituted by layers formed by mixing a plurality of materials, or constituted by layers each formed singly by the respective materials and layers formed by mixing a plurality of materials. These materials can form thin films by known methods, such as vapor deposition, spin coating, ink-jetting, etc.

### Examples

Embodiments of the present invention will be described in further detail below according to working examples. Note, however, that the present invention is not limited to the following examples.

### Synthesis Example 1:

### Synthesis of bis(4-naphthalen-2-yl-phenyl)-(2',5'-diphenyl-biphenyl-4-yl)-amine (Compound (1-4)):

A reaction vessel was charged with 10.0 g of bis(4-naphthalen-2-yl-phenyl)-amine, 11.0 g of 4-bromo-2',5'-diphenyl-biphenyl, 0.1 g of palladium(II) acetate, 0.2 g of tri(t-butyl)phosphine, and 2.7 g of sodium t-butoxide, and the mixture was stirred under reflux for 3 hours in a toluene solvent. After the mixture was allowed to cool, a filtrate obtained by filtering was concentrated, to obtain a crude product. The obtained crude product was purified by crystallization with a toluene/acetone mixed solvent, to obtain 9.0 g of a white powder of bis(4-naphthalen-2-yl-phenyl)-(2',5'-diphenyl-biphenyl-4-yl)-amine (Compound (1-4)) (yield: 52.3%).

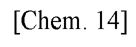

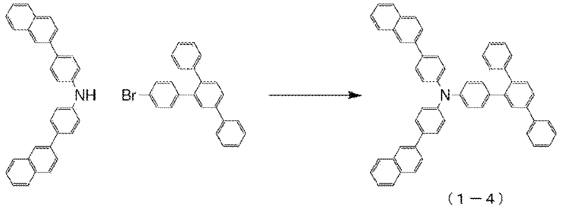

The structure of the obtained white powder was identified by detecting the following 39 hydrogen signals with ¹H-NMR (CDCl₃) measurement.

δ (ppm) = 8.06 (2H), 7.92 (6H), 7.78 (4H), 7.73 (1H), 7.68 (5H), 7.53 (7H), 7.42 (1H), 7.39-7.23 (9H), 7.14 (4H).

### Synthesis Example 2:

### Synthesis of (2',5'-diphenyl-biphenyl-4-yl)-(4-naphthalen-1-yl-phenyl)-phenanthren-9-yl-amine (Compound (1-58)):

A reaction vessel was charged with 8.5 g of (2',5'-diphenyl-biphenyl-4-yl)-(4-naphthalen-1-yl-phenyl)-amine, 4.8 g of 9-bromo-phenanthrene, 0.1 g of palladium(II) acetate, 0.3 g of tri(t-butyl)phosphine, and 2.3 g of sodium t-butoxide, and the mixture was stirred under reflux for 3 hours in a toluene solvent. After the mixture was allowed to cool, a filtrate obtained by filtering was concentrated, to obtain a crude product. The obtained crude product was purified by crystallization with a toluene/acetone mixed solvent, to obtain 8.3 g of a white powder of (2',5'-diphenyl-biphenyl-4-yl)-(4-naphthalen-1-yl-phenyl)-phenanthren-9-yl-amine (Compound (1-58)) (yield: 73.1%).

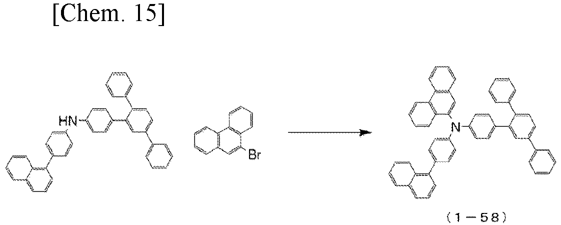

The structure of the obtained white powder was identified by detecting the following 37 hydrogen signals with ¹H-NMR (CDCl₃) measurement.

δ (ppm) = 8.79 (1H), 8.75 (1H), 8.14 (1H), 8.03 (1H), 7.92 (1H), 7.85 (2H), 7.72 (6H), 7.65 (2H), 7.60 (1H), 7.50 (7H), 7.42 (1H), 7.36 (3H), 7.27-7.18 (6H), 7.09 (4H).

### Synthesis Example 3:

### Synthesis of (2',5'-diphenyl-biphenyl-4-yl)-(4-naphthalen-2-yl-phenyl)-phenanthren-9-yl-amine (Compound (1-59)):

A reaction vessel was charged with 8.0 g of (2',5'-diphenyl-biphenyl-4-yl)-(4-naphthalen-2-yl-phenyl)-amine, 4.5 g of 9-bromo-phenanthrene, 0.1 g of palladium(II) acetate, 0.2 g of tri(t-butyl)phosphine, and 2.2 g of sodium t-butoxide, and the mixture was stirred under reflux for 3 hours in a toluene solvent. After the mixture was allowed to cool, a filtrate obtained by filtering was concentrated, to obtain a crude product. The obtained crude product was purified by crystallization with a toluene/acetone mixed solvent, to obtain 6.6 g of a pale-yellow powder of (2',5'-diphenyl-biphenyl-4-yl)-(4-naphthalen-2-yl-phenyl)-phenanthren-9-yl-amine (Compound (1-59)) (yield: 61.7%).

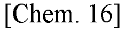

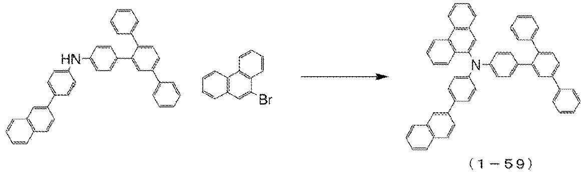

The structure of the obtained pale-yellow powder was identified by detecting the following 37 hydrogen signals with ¹H-NMR (CDCl₃) measurement.

δ (ppm) = 8.79 (1H), 8.74 (1H), 8.09 (1H), 8.01 (1H), 7.86 (4H), 7.75 (1H), 7.71 (5H), 7.66 (2H), 7.60 (3H), 7.50 (5H), 7.39 (1H), 7.34-7.23 (6H), 7.20 (2H), 7.07 (4H).

### Synthesis Example 4:

### Synthesis of (2",5"-diphenyl-[1,1';4',1"]terphenyl-4-yl)-(4-naphthalen-2-yl-phenyl)-phenyl-amine (Compound (1-69)):

A reaction vessel was charged with 6.0 g of (4-naphthalen-2-yl-phenyl)-phenylamine, 10.3 g of 4-bromo-2",5"-diphenyl-[1,1';4',1"]terphenyl, 0.1 g of palladium(II) acetate, 0.2 g of tri(t-butyl)phosphine, and 2.3 g of sodium t-butoxide, and the mixture was stirred under reflux overnight in a toluene solvent. After the mixture was allowed to cool, a filtrate obtained by filtering was concentrated, to obtain a crude product. The obtained crude product was purified by column chromatography (adsorbent: silica gel; eluent: dichloromethane/n-heptane), to obtain 7.1 g of a white powder of (2",5"-diphenyl-[1,1';4',1"]terphenyl-4-yl)-(4-naphthalen-2-yl-phenyl)-phenyl-amine (Compound (1-69)) (yield: 51.7%).

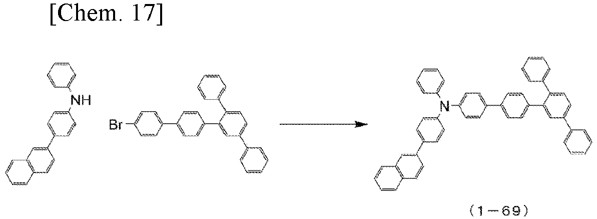

The structure of the obtained white powder was identified by detecting the following 37 hydrogen signals with ¹H-NMR (CDCl₃) measurement.

δ (ppm) = 8.04 (1H), 7.91 (3H), 7.73 (5H), 7.66 (2H), 7.56 (2H), 7.51 (7H), 7.42 (1H), 7.39-7.18 (15H), 7.10 (1H).

### Synthesis Example 5:

### Synthesis of (2",5"-diphenyl-[1,1';4',1"]terphenyl-4-yl)-(4-phenanthren-9-yl-phenyl)-phenyl-amine (Compound (1-83)):

A reaction vessel was charged with 11.0 g of (4-phenanthren-9-yl-phenyl)-phenylamine, 16.2 g of 4-bromo-2",5"-[1,1';4',1"]terphenyl, 0.1 g of palladium(II) acetate, 0.3 g of tri(t-butyl)phosphine, and 3.7 g of sodium t-butoxide, and the mixture was stirred under reflux overnight in a toluene solvent. After the mixture was allowed to cool, a filtrate obtained by filtering was concentrated, to obtain a crude product. The obtained crude product was purified by column chromatography (adsorbent: silica gel; eluent: dichloromethane/n-heptane), to obtain 11.2 g of a white powder of (2",5"-diphenyl-[1,1';4',1"]terphenyl-4-yl)-(4-phenanthren-9-yl-phenyl)-phenyl-amine (Compound (1-83)) (yield: 48.5%).

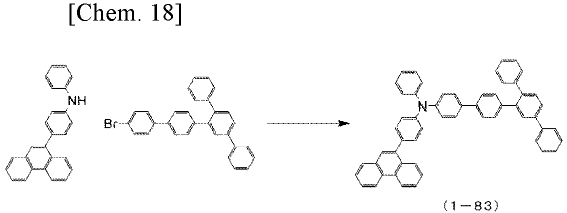

The structure of the obtained white powder was identified by detecting the following 39 hydrogen signals with ¹H-NMR (CDCl₃) measurement.

δ (ppm) = 8.81 (1H), 8.75 (1H), 8.09 (1H), 7.93 (1H), 7.71 (7H), 7.65-7.44 (10H), 7.44-7.22 (17H), 7.11 (1H).

### Synthesis Example 6:

### Synthesis of N-(3'-(naphthalen-2-yl)-[1,1'-biphenyl]-4-yl)-N-(4-(naphthalene)-2-yl)phenyl)-5'-phenyl-[1,1':2',1"-terphenyl]-4-amine (Compound (1-96)):

A reaction vessel was charged with 50.0 g of 4-bromoaniline, 113.9 g of 4,4,5,5-tetramethyl-2-[1,1':4',1"-terphenyl]-2'-yl-1,3,2-dioxaborolane, 350 mL of toluene, 88 mL of ethanol, 80.4 g of potassium carbonate, and 290 mL of water, then 6.7 g of tetrakis(triphenylphosphine)palladium was added thereto, and the mixture was stirred under reflux for 14 hours. After the mixture was allowed to cool, the mixture was separated, and the organic layer was sequentially washed with water and saturated saline solution, and was then dried with anhydrous magnesium sulfate. The desiccant was removed by filtration, and the filtrate was concentrated. Then, 450 mL of heptane was added to the residue and was stirred overnight at room temperature, and the solid was collected by filtration, to obtain 77.8 g of a yellowish-white powder of [1,1':2',1":4",1‴-quaterphenyl]-4-amine (yield: 83.3%).

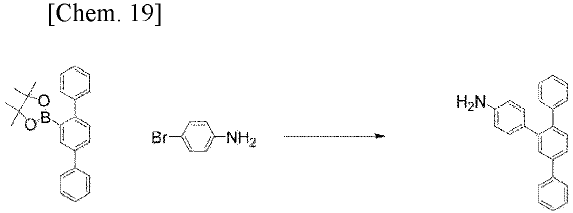

A reaction vessel was charged with 55.0 g of [1,1':2',1":4",1‴-quaterphenyl]-4-amine, 74.9 g of 2-(4-bromophenyl)naphthalene, 28.0 g of sodium t-butoxide, 420 mL of toluene, 0.9 g of tris(dibenzylideneacetone)dipalladium, and 2.4 g of 2,2'-bis(diphenylphosphino)-1,1'-binaphthyl, and the mixture was stirred under reflux for 15 hours. The mixture was cooled to 80°C, and the solid was removed by hot filtration using a celite-padded funnel. The filtrate was heated and stirred, then 50 g of silica gel was added at 80°C and was stirred for 1 hour, and the solid was removed by hot filtration. The filtrate was concentrated, and the residue was recrystallized with a toluene/acetone mixed solvent, to obtain 69.5 g of a yellowish-white powder of N-(4-(2-naphthyl)phenyl)-[1,1':2',1":4",1‴-quaterphenyl]-4-amine (yield: 68.3%).

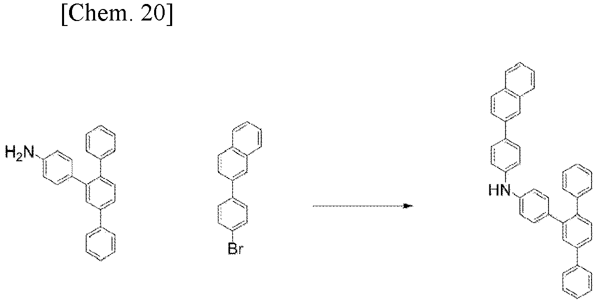

A reaction vessel was charged with 69.5 g of N-(4-(2-naphthyl)phenyl)-[1,1':2',1":4",1‴-quaterphenyl]-4-amine, 45.1 g of 1-bromo-4-iodobenzene, 25.7 g of sodium t-butoxide, 700 mL of toluene, 2.5 g of copper iodide, and 2.3 g of N,N'-dimethylethylenediamine, and the mixture was stirred under reflux for 16 hours. The mixture was cooled to 80°C, and the solid was removed by hot filtration using a celite-padded funnel. The filtrate was concentrated, and the residue was purified by column chromatography (adsorbent: silica gel; eluent: dichloromethane/n-heptane), to obtain 59.4 g of a yellowish-white powder of N-(4-bromophenyl)-N-(4-(2-naphthyl)phenyl)-[1,1':2',1":4",1‴-quaterphenyl]-4-amine (yield: 65.5%).

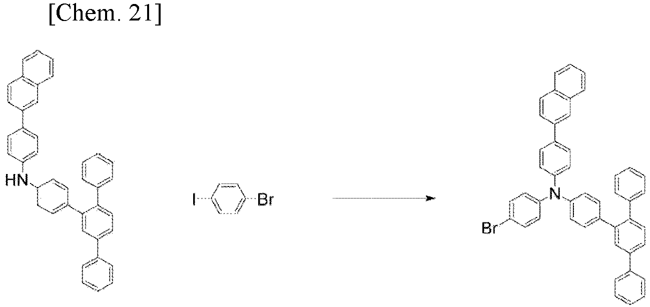

A reaction vessel was charged with 12.0 g of N-(4-bromophenyl)-N-(4-(2-naphthyl)phenyl)-[1,1':2',1":4",1‴-quaterphenyl]-4-amine, 5.3 g of 3-(2-naphthyl)phenylboronic acid, 84 mL of toluene, 21 mL of ethanol, 4.9 g of potassium carbonate, and 18 mL of water, then 0.4 g of tetrakis(triphenylphosphine)palladium was added thereto, and the mixture was stirred under reflux for 14 hours. After the mixture was allowed to cool, 84 mL of methanol was added, and the precipitated solid was collected by filtration. To the solid, 70 mL of water and 70 mL of methanol were added, and dispersion washing was performed for 1 hour under reflux. The solid was collected by filtration, then 140 mL of toluene was added thereto, and this was once heated to 100°C to remove water and methanol. The mixture was then cooled to 80°C, and 7 g of silica gel and 7 g of activated clay were added thereto and stirred for 1 hour. The solid was removed by filtration, and the filtrate was concentrated. Then, 140 mL of acetone was added to the residue and was stirred overnight at room temperature, and the solid was collected by filtration. The solid was recrystallized with a toluene/acetone mixed solvent, to obtain 11.3 g of a yellowish-white powder of N-(3'-(naphthalen-2-yl)-[1,1'-biphenyl]-4-yl)-N-(4-(naphthalene)-2-yl)phenyl)-5'-phenyl-[1,1':2',1"-terphenyl]-4-amine (Compound (1-96)) (yield: 79.6%).

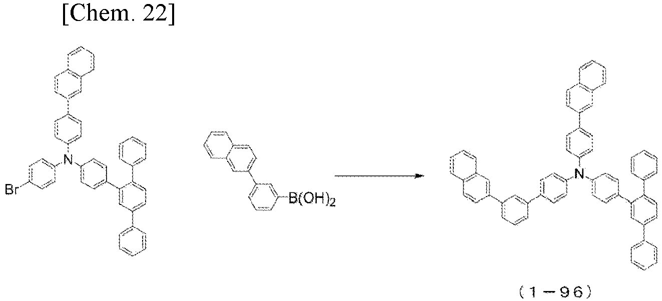

The structure of the obtained yellowish-white powder was identified by detecting the following 43 hydrogen signals with ¹H-NMR (CDCl₃) measurement.

δ (ppm) = 8.09 (1H), 8.01 (1H), 7.77-7.92 (8H), 7.43-7.73 (19H), 7.21-7.38 (10H), 7.04-7.13 (4H).

### Synthesis Example 7:

### Synthesis of N,9,9-triphenyl-N-(4'-phenyl-[1,1':2',1":4",1‴-quaterphenyl]-4‴-yl)-9H-fluorene-2-amine (Compound (1-97)):

A reaction vessel was charged with 20.0 g of 2'-chloro-[1,1':4',1"-terphenyl], 29.5 g of N-phenyl-4'-(4,4,5,5-tetramethyl-1,3,2-dioxaborolane-2-yl)-[1,1'-biphenyl]-4-amine, 200 mL of 1,4-dioxane, 32.1 g of potassium phosphate, and 60 mL of water, then 2.1 g of tris(dibenzylideneacetone)dipalladium and 2.1 g of tricyclohexyl phosphine were further added thereto, and the mixture was stirred under reflux for 14 hours. After the mixture was allowed to cool, 200 mL of methanol was added, and the precipitated solid was collected by filtration. Then, 360 mL of chlorobenzene was added to the solid, and this was once heated to 100°C. This was then cooled to 80°C, and 9 g of silica gel and 9 g of activated clay were added thereto and stirred for 1 hour. The solid was removed by filtration, and the filtrate was concentrated. Then, 360 mL of acetone was added to the residue and was stirred overnight at room temperature, and the solid was collected by filtration, to obtain 30.6 g of a yellowish-white powder of N,4'-diphenyl-[1,1':2',1":4",1‴-terphenyl]-4‴-amine (yield: 85.5%).

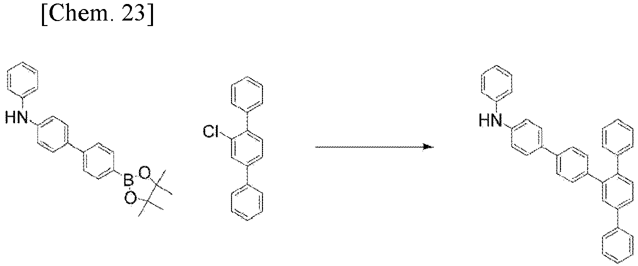

A reaction vessel was charged with 20.0 g of N,4'-diphenyl-[1,1':2',1":4",1‴-terphenyl]-4'''-amine, 18.5 g of 2-bromo-9,9-diphenyl-9H-fluorene, 200 mL of toluene, and 6.1 g of sodium t-butoxide, then 0.1 g of tris(dibenzylideneacetone)dipalladium and 0.2 g of a 50% toluene solution of tri(t-butyl)phosphine were added thereto, and the mixture was stirred under reflux for 14 hours. The mixture was cooled to 80°C, and then hot filtration was performed using a celite-padded funnel to remove the solid. The filtrate was heated and stirred, and then 12 g of silica gel and 12 g of activated clay were added thereto at 80°C and stirred for 1 hour. The solid was removed by filtration, and the filtrate was concentrated. The residue was recrystallized with a toluene/acetone mixed solvent, to obtain 21.4 g of a yellowish-white powder of N,9,9-triphenyl-N-(4'-phenyl-[1,1':2',1":4",1‴-quaterphenyl]-4‴-yl)-9H-fluorene-2-amine (Compound (1-97)) (yield: 64.1%).

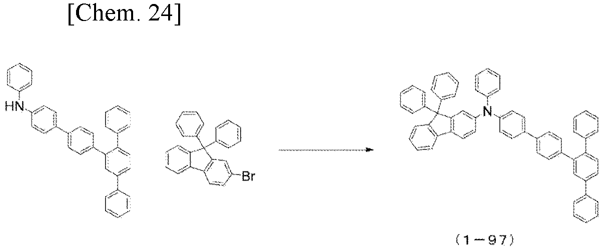

The structure of the obtained yellowish-white powder was identified by detecting the following 43 hydrogen signals with ¹H-NMR (CDCl₃) measurement.

δ (ppm) = 7.64-7.71 (5H), 7.58-7.60 (1H), 7.51-7.53 (1H), 7.41-7.48 (6H), 7.30-7.38 (3H), 7.14-7.24 (21H), 6.98-7.09 (6H).

### Synthesis Example 8:

### Synthesis of N-([1,1'-biphenyl]-4-yl)-5'-(naphthalen-2-yl)-N-(4-(naphthalen-2-yl)phenyl)-[1,1':2',1"-terphenyl]-4-amine (Compound (1-102)):

A reaction vessel was charged with 31.0 g of 4-bromo-2-chloro-1,1'-biphenyl, 22.0 g of 2-naphthaleneboronic acid, 240 mL of toluene, 60 mL of ethanol, 24.1 g of potassium carbonate, and 80 mL of water, then 1.3 g of tetrakis(triphenylphosphine)palladium was added thereto, and the mixture was stirred under reflux for 15 hours. After the mixture was allowed to cool, the mixture was separated, and the organic layer was washed with water. The organic layer was stirred and once heated to 100°C to confirm that no water is included. This was then cooled to 80°C and 20 g of silica gel was added thereto and stirred for 1 hour. The solid was removed by hot filtration, and the filtrate was concentrated. The residue was recrystallized with a toluene/heptane mixed solvent, to obtain 25.6 g of a gray powder of 2-(2-chloro-[1,1'-biphenyl]-4-yl)naphthalene (yield: 63.5%).

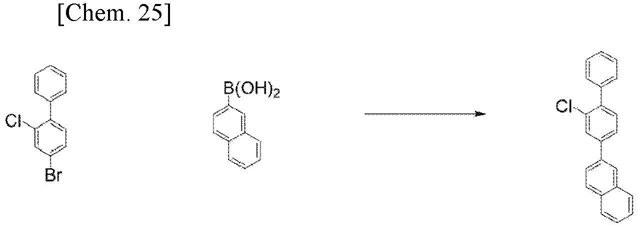

A reaction vessel was charged with 20.0 g of 2-(2-chloro-[1,1'-biphenyl]-4-yl)naphthalene, 24.8 g of N-(4-(4,4,5,5-tetramethyl-1,3,2-dioxaborolane-2-yl)phenyl)-[1,1'-biphenyl]-4-amine, 160 mL of 1,4-dioxane, 27.0 g of potassium phosphate, and 60 mL of water, then 1.8 g of tris(dibenzylideneacetone)dipalladium and 1.8 g of tricyclohexyl phosphine were added thereto, and the mixture was stirred under reflux for 12 hours. After the mixture was allowed to cool, the mixture was concentrated. The residue, with water remaining, was extracted with toluene, and the organic layer was sequentially washed with water and saturated saline solution and was then dried with anhydrous magnesium sulfate. The desiccant was removed by filtration, and the filtrate was stirred and heated, and then 20 g of silica gel was added at 80°C and was stirred for 1 hour. The solid was then removed by hot filtration, and the filtrate was concentrated. The residue was recrystallized with a toluene solvent, to obtain 26.0 g of a yellowish-white powder of N-([1,1'-biphenyl]-4-yl)-5'-(naphthalen-2-yl)-[1,1':2',1"-terphenyl]-4-amine (yield: 78.0%).

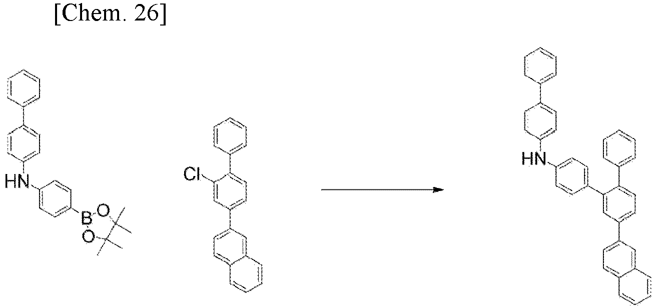

A reaction vessel was charged with 24.6 g of N-([1,1'-biphenyl]-4-yl)-5'-(naphthalen-2-yl)-[1,1' :2',1"-terphenyl]-4-amine, 14.7 g of 2-(4-bromophenyl)naphthalene, 250 mL of toluene, and 6.8 g of sodium t-butoxide, then 0.4 g of tris(dibenzylideneacetone)dipalladium and 0.4 g of a 50% toluene solution of tri(t-butyl)phosphine were added thereto, and the mixture was stirred under reflux for 4 hours. The mixture was cooled to 80°C, and then hot filtration was performed using a celite-padded funnel to remove the solid. The filtrate was heated and stirred, and then 17 g of silica gel and 17 g of activated clay were added at 80°C and stirred for 1 hour. The solid was removed by filtration, and the filtrate was concentrated. The residue was purified by crystallization with a toluene/acetone mixed solvent, to obtain 21.0 g of a yellowish-white powder of N-([1,1'-biphenyl]-4-yl)-5'-(naphthalen-2-yl)-N-(4-(naphthalen-2-yl)phenyl)-[1,1':2',1"-terphenyl]-4-amine (Compound (1-102)) (yield: 61.5%).

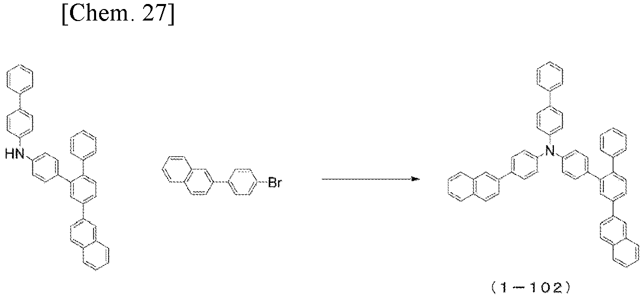

The structure of the obtained yellowish-white powder was identified by detecting the following 39 hydrogen signals with ¹H-NMR (CDCl₃) measurement.

δ (ppm) = 8.14 (1H), 8.01 (1H), 7.82-7.93 (8H), 7.71-7.77 (2H), 7.39-7.63 (13H), 7.05-7.32 (14H).

### Synthesis Example 9:

### Synthesis of N-([1,1'-biphenyl]-4-yl)-5'-phenyl-N-(4-(3-phenylnaphthalen-1-yl)phenyl)-[1,1':2',1"-terphenyl]-4-amine (Compound (1-103)):

A reaction vessel was charged with 32.7 g of 2'-bromo-[1,1':4',1"-terphenyl], 24.8 g of N-(4-(4,4,5,5-tetramethyl-1,3,2-dioxaborolane-2-yl)phenyl)-[1,1'-biphenyl]-4-amine, 320 mL of toluene, 90 mL of ethanol, 21.9 g of potassium carbonate, and 80 mL of water, then 1.2 g of tetrakis(triphenylphosphine)palladium was added thereto, and the mixture was stirred under reflux for 13 hours. The mixture was allowed to cool, and the precipitated solid was collected by filtration. Then, 250 mL of methanol and 250 mL of water were added thereto, dispersion washing was performed for 1 hour under reflux, and then the solid was collected by filtration. To the solid, 750 mL of toluene was added and stirred, and this was once heated to 100°C to confirm that methanol and water were removed, and then the mixture was cooled to 80°C. Then, 10 g of silica gel was added and stirred for 1 hour, and the solid was removed by hot filtration. The filtrate was concentrated, and the residue was crystallized by an acetone solvent, to obtain 33.0 g of a yellowish-white powder of N-([1,1'-biphenyl]-4-yl)-5'-phenyl-[1,1':2',1"-terphenyl]-4-amine (yield: 65.9%).

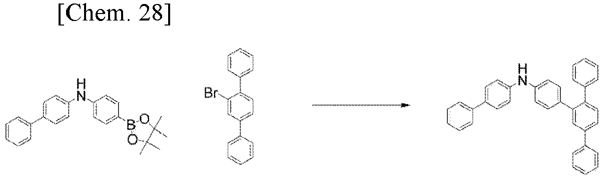

A reaction vessel was charged with 10.2 g of N-([1,1'-biphenyl]-4-yl)-5'-phenyl-[1,1':2',1"-terphenyl]-4-amine, 7.0 g of 1-(4-bromophenyl)-3-phenylnaphthalene, 70 mL of toluene, and 2.8 g of sodium t-butoxide, then 0.1 g of palladium acetate and 0.4 g of a 50% toluene solution of tri(t-butyl)phosphine were added thereto, and the mixture was stirred under reflux for 4 hours. The mixture was cooled to room temperature, then methanol was added thereto, and the precipitated solid was collected by filtration. To the solid, 300 mL of toluene was added, stirred, and heated, and then 7 g of silica gel and 7 g of activated clay were added at 80°C and stirred for 1 hour. The solid was removed by hot filtration, and the filtrate was concentrated. The residue was recrystallized with a dichloromethane/acetone mixed solvent, to obtain 10.9 g of a white powder of N-([1,1'-biphenyl]-4-yl)-5'-phenyl-N-(4-(3-phenylnaphthalen-1-yl)phenyl)-[1,1' :2',1"-terphenyl]-4-amine (Compound (1-103)) (yield: 74.2%).

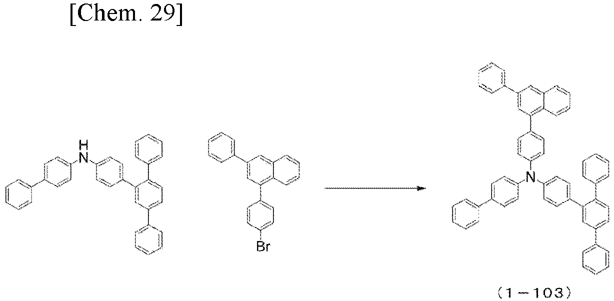

The structure of the obtained white powder was identified by detecting the following 41 hydrogen signals with ¹H-NMR (CDCl₃) measurement.

δ (ppm) = 8.01-8.03 (2H), 7.94-7.96 (1H), 7.58-7.77 (9H), 7.22-7.53 (25H), 7.08-7.15 (4H).

### Synthesis Example 10:

### Synthesis of N,N-bis(biphenyl-4-yl)-6-(9,9-dimethylfluoren-2-yl)biphenyl-3-amine (Compound (3-52)):

A reaction vessel was charged with 13.0 g of N,N-bis(biphenyl-4-yl)-6-bromobiphenyl-3-amine, 6.8 g of (9,9-dimethylfluoren-2-yl)boronic acid, 3.9 g of potassium carbonate, and 0.54 g of tetrakis(triphenylphosphine)palladium, then 100 mL of toluene, 26 mL of ethanol, and 40 mL of water were added thereto, and the mixture was stirred under reflux overnight. After the mixture was allowed to cool, the organic layer was fractionated and sequentially washed with water and saturated saline solution. The organic layer was dried with anhydrous magnesium sulfate, and the desiccant was removed by filtration. The filtrate was concentrated, and the residue was purified by column chromatography (silica gel; heptane:toluene = 2:1), to obtain 9.0 g of a pale-yellow powder of N,N-bis(biphenyl-4-yl)-6-(9,9-dimethylfluoren-2-yl)biphenyl-3-amine (Compound (3-52)) (yield: 57%).

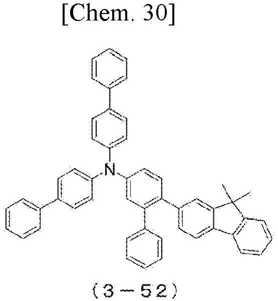

The structure of the obtained white powder was identified by detecting the following 39 hydrogen signals with ¹H-NMR (CDCl₃) measurement.

δ (ppm) = 7.22-7.68 (28H), 7.12 (4H), 6.99 (1H), 1.22 (6H).

### Synthesis Example 11:

### Synthesis of N-biphenyl-4-yl-N-[2-(9,9-diphenylfluoren-4-yl)phenyl]-9,9-diphenylfluorene-2-amine (Compound (3-130)):

A reaction vessel was charged with 20.0 g of N-biphenyl-4-yl-9,9-dimethylfluorene-2-amine, 28.8 g of 4-(2-bromophenyl)-9,9-dimethylfluorene, 8.0 g of sodium t-butoxide, and 200 mL of toluene, then 0.12 g of palladium acetate and 0.45 g of a 50% toluene solution of t-butylphosphine were added thereto, and the mixture was stirred under reflux for 4 hours. After the mixture was allowed to cool, a filtrate obtained by filtering was concentrated, to obtain a crude product. The obtained crude product was purified by column chromatography (silica gel; heptane:toluene = 2:1), to obtain 31.3 g of a white powder of N-biphenyl-4-yl-N-[2-(9,9-diphenylfluoren-4-yl)phenyl]-9,9-diphenylfluorene-2-amine (Compound (3-130)) (yield: 75.0%).

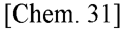

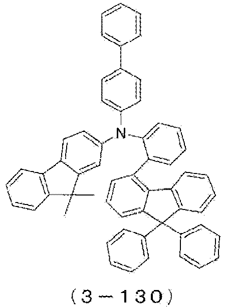

The structure of the obtained white powder was identified by detecting the following 43 hydrogen signals with ¹H-NMR (CDCl₃) measurement.

δ (ppm) = 7.46-7.55 (4H), 6.79-7.38 (29H), 6.67-6.69 (2H), 6.47-6.51 (2H), 1.08 (3H), 1.01 (3H).

### Synthesis Example 12:

### Synthesis of Compound (5-1-11):

A reaction vessel was charged with 45.0 g of 1-bromobenzene (deuterated), 58.0 g of 4-tert-butylaniline, 1.0 g of palladium(II) acetate, 30.0 g of sodium t-butoxide, 2.0 g of bis(diphenylphosphino)-1,1'-binaphthyl, and 450 mL of toluene, and the mixture was stirred under reflux for 24 hours. The mixture was allowed to cool, then concentrated, and purified by column chromatography, to obtain 49.9 g of a powder of the following Compound (5-1-11a) (yield: 78%).

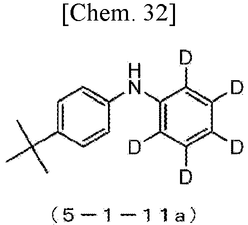

A reaction vessel was charged with 20.0 g of the aforementioned Compound (5-1-11a), 18.4 g of the following Compound (5-1-11b), 0.5 g of palladium(II) acetate, 18.9 g of sodium t-butoxide, 0.8 g of tri(t-butyl)phosphine, and 200 mL of toluene, and the mixture was stirred under reflux for 24 hours. The mixture was allowed to cool, then concentrated, and purified by column chromatography, to obtain 21.5 g of a powder of the following Compound (5-1-11c) (yield: 84%).

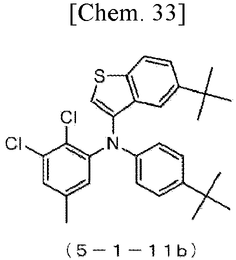

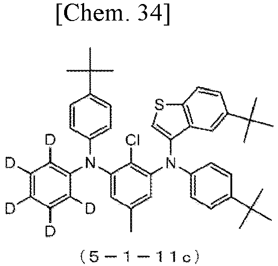

A reaction vessel was charged with 12.0 g of the aforementioned Compound (5-1-11c) and 120 ml of tert-butylbenzene, and at -78°C, 42.5 ml of n-butyllithium was dropped. Then, the mixture was aerated with nitrogen gas while being stirred at 60°C for 3 hours. Next, at -78°C, 11.3 g of boron tribromide was dropped, and the mixture was stirred at atmospheric temperature for 1 hour. Then, at 0°C, 5.9 g of N,N-diisopropylethylamine was dropped, and the mixture was stirred at 120°C for 2 hours. After the mixture was allowed to cool, a sodium acetate aqueous solution was added and stirred, and then extraction was performed with ethyl acetate. The organic layer was concentrated, purification was performed by column chromatography, to obtain 1.7 g of a powder of the following Compound (5-1-11) (yield: 11%).

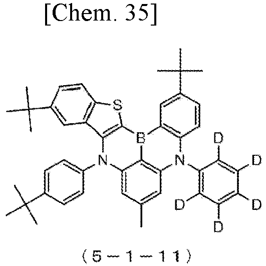

The glass transition point was measured for each of the triarylamine compounds represented by general formula (1) or (3) as obtained in Synthesis Examples 1 to 11 by using a high-sensitivity differential scanning calorimeter (DSC3100SAfrom Bruker AXS). The results are shown below.
Compound (1-4): 107.1°C
Compound (1-58): 131.2°C
Compound (1-59): 129.7°C
Compound (1-69): 110.0°C
Compound (1-83): 127.9°C
Compound (1-96): 109.5°C
Compound (1-97): 136.2°C
Compound (1-102): 109.1°C
Compound (1-103): 118.7°C
Compound (3-52): 114.6°C
Compound (3-130): 137.3°C

These measurement results show that the triarylamine compounds represented by general formula (1) or (3) to be used in the present invention have a glass transition point of 100°C or higher. This shows that the thin-film state is stable.

A 100-nm-thick vapor deposition film was formed on an ITO substrate by using the respective triarylamine compounds represented by general formula (1) or (3) as obtained in Synthesis Examples 1 to 11, and the HOMO level (ionization potential) of each layer was measured using an ionization potential measurement device (PYS-202 from Sumitomo Heavy Industries, Ltd.). The results are shown below.
Compound (1-4): 5.67 eV
Compound (1-58): 5.72 eV
Compound (1-59): 5.75 eV
Compound (1-69): 5.72 eV
Compound (1-83): 5.76 eV
Compound (1-96): 5.69 eV
Compound (1-97): 5.68 eV
Compound (1-102): 5.67 eV
Compound (1-103): 5.73 eV
Compound (3-52): 5.66 eV
Compound (3-130): 5.67 eV

For comparison, the HOMO level was measured also for layers formed respectively using Compounds (HTM-1), (HTM-2), and (HTM-3) having the following structural formulas.

The measurement results are shown below.
Compound (HTM-1): 5.50 eV
Compound (HTM-2): 5.68 eV
Compound (HTM-3): 5.73 eV

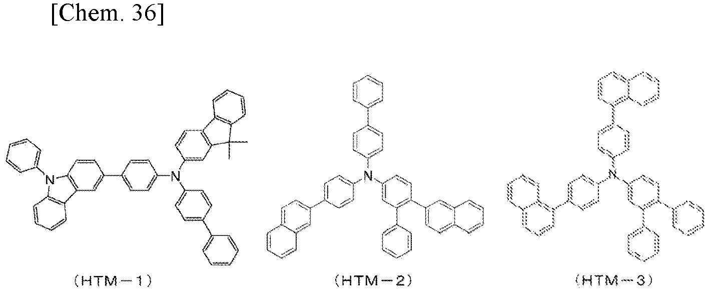

These measurement results show that the triarylamine compounds represented by general formula (1) have a suitable energy level and have good hole transportability, compared to the HOMO level of 5.4 eV of typical hole-transporting materials such as NPD, TPD, etc.

### Example 1:

As illustrated in Fig. 44, an organic EL device was prepared by vapor-depositing a hole injection layer 3, a first hole transport layer 4, a second hole transport layer 5, a light-emitting layer 6, an electron transport layer 7, an electron injection layer 8, a cathode 9, and a capping layer 10 in this order onto a glass substrate 1 having formed thereon a reflective ITO electrode as a transparent anode 2 in advance.

More specifically, a glass substrate 1 having formed thereon, in order, a 50-nm-thick ITO film, a 100-nm-thick silver-alloy reflective film, and a 5-nm-thick ITO film was subjected to ultrasonic cleaning in isopropyl alcohol for 20 minutes, and then dried for 10 minutes on a hot plate heated to 250°C. Then, after UV ozone treatment for 15 minutes, the glass substrate having the ITO was mounted to a vacuum vapor deposition apparatus, in which the pressure was reduced to 0.001 Pa or lower.

Next, a hole injection layer 3 was formed so as to cover the transparent anode 2 and so that the film thickness was 10 nm, by performing binary vapor deposition of an electron acceptor (Acceptor-1) having the following structural formula and Compound (3-52) of Example 10 at a rate at which the vapor deposition rate ratio between Acceptor-1 and Compound (3-52) was 3:97.

On this hole injection layer 3, Compound (3-52) of Example 10 was formed as a first hole transport layer 4 having a film thickness of 140 nm.

On this first hole transport layer 4, Compound (1-4) of Example 1 was formed as a second hole transport layer 5 having a film thickness of 5 nm.

On this second hole transport layer 5, a light-emitting layer 6 was formed so that the film thickness was 20 nm, by performing binary vapor deposition of Compound (5-1-11) of Example 8 and Compound (EMH-1) having the following structural formula at a rate at which the vapor deposition rate ratio between Compound (5-1-11) and Compound (EMH-1) was 5:95.

On this light-emitting layer 6, an electron transport layer 7 was formed so that the film thickness was 30 nm, by performing binary vapor deposition of Compound (ETM-1) having the following structural formula and Compound (ETM-2) having the following structural formula at a rate at which the vapor deposition rate ratio between Compound (ETM-1) and Compound (ETM-2) was 50:50.

On this electron transport layer 7, lithium fluoride was formed as an electron injection layer 8 having a film thickness of 1 nm.

On this electron injection layer 8, a magnesium-silver alloy was formed as a cathode 9 having a film thickness of 12 nm.

Finally, Compound (CPL-1) having the following structure was formed as a capping layer 10 having a film thickness of 60 nm.

Light emission properties of the produced organic EL device were measured by applying a direct-current voltage thereto in the atmosphere at atmospheric temperature such that a current with a current density of 10 mA/cm² was passed therethrough. The results are collectively shown in Table 2.

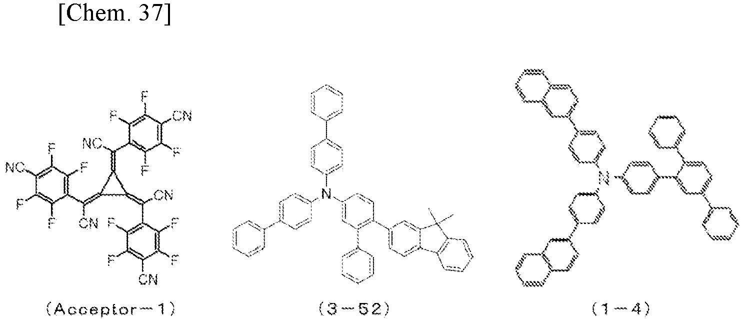

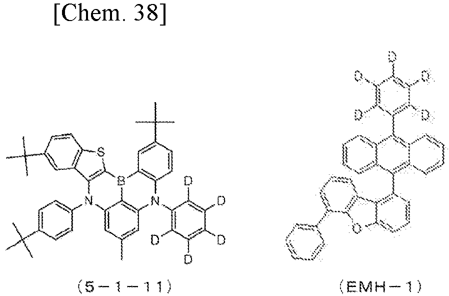

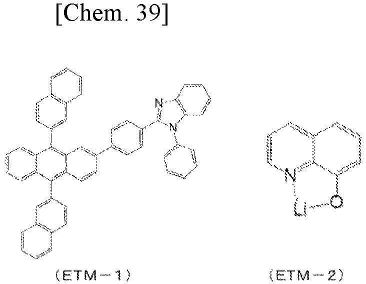

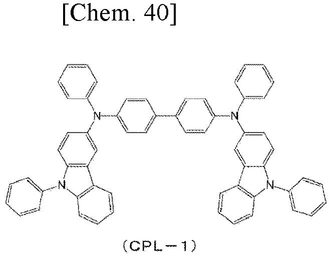

### Example 2:

An organic EL device was produced according to the same conditions, except that, in Example 1, Compound (1-58) was used instead of Compound (1-4) as the material for the second hole transport layer 5, and light-emitting properties were measured in the same manner. The results are collectively shown in Table 2.

### Example 3:

An organic EL device was produced according to the same conditions, except that, in Example 1, Compound (1-59) was used instead of Compound (1-4) as the material for the second hole transport layer 5, and light-emitting properties were measured in the same manner. The results are collectively shown in Table 2.

### Example 4:

An organic EL device was produced according to the same conditions, except that, in Example 1, Compound (1-69) was used instead of Compound (1-4) as the material for the second hole transport layer 5, and light-emitting properties were measured in the same manner. The results are collectively shown in Table 2.

### Example 5:

An organic EL device was produced according to the same conditions, except that, in Example 1, Compound (1-83) was used instead of Compound (1-4) as the material for the second hole transport layer 5, and light-emitting properties were measured in the same manner. The results are collectively shown in Table 2.

### Example 6:

An organic EL device was produced according to the same conditions, except that, in Example 1, Compound (3-130) was used instead of Compound (3-52) as the material for the hole injection layer 3 and the first hole transport layer 4, and light-emitting properties were measured in the same manner. The results are collectively shown in Table 2.

### Example 7:

An organic EL device was produced according to the same conditions, except that, in Example 2, Compound (3-130) was used instead of Compound (3-52) as the material for the hole injection layer 3 and the first hole transport layer 4, and light-emitting properties were measured in the same manner. The results are collectively shown in Table 2.

### Example 8:

An organic EL device was produced according to the same conditions, except that, in Example 3, Compound (3-130) was used instead of Compound (3-52) as the material for the hole injection layer 3 and the first hole transport layer 4, and light-emitting properties were measured in the same manner. The results are collectively shown in Table 2.

### Example 9:

An organic EL device was produced according to the same conditions, except that, in Example 4, Compound (3-130) was used instead of Compound (3-52) as the material for the hole injection layer 3 and the first hole transport layer 4, and light-emitting properties were measured in the same manner. The results are collectively shown in Table 2.

### Example 10:

An organic EL device was produced according to the same conditions, except that, in Example 5, Compound (3-130) was used instead of Compound (3-52) as the material for the hole injection layer 3 and the first hole transport layer 4, and light-emitting properties were measured in the same manner. The results are collectively shown in Table 2.

### Example 11:

An organic EL device was produced according to the same conditions, except that, in Example 1, Compound (1-96) was used instead of Compound (1-4) as the material for the second hole transport layer 5, and light-emitting properties were measured in the same manner. The results are collectively shown in Table 2.

### Example 12:

An organic EL device was produced according to the same conditions, except that, in Example 1, Compound (1-97) was used instead of Compound (1-4) as the material for the second hole transport layer 5, and light-emitting properties were measured in the same manner. The results are collectively shown in Table 2.

### Example 13:

An organic EL device was produced according to the same conditions, except that, in Example 1, Compound (1-102) was used instead of Compound (1-4) as the material for the second hole transport layer 5, and light-emitting properties were measured in the same manner. The results are collectively shown in Table 2.

### Example 14:

An organic EL device was produced according to the same conditions, except that, in Example 1, Compound (1-103) was used instead of Compound (1-4) as the material for the second hole transport layer 5, and light-emitting properties were measured in the same manner. The results are collectively shown in Table 2.

### Example 15:

An organic EL device was produced according to the same conditions, except that, in Example 11, Compound (3-130) was used instead of Compound (3-52) as the material for the hole injection layer 3 and the first hole transport layer 4, and light-emitting properties were measured in the same manner. The results are collectively shown in Table 2.

### Example 16:

An organic EL device was produced according to the same conditions, except that, in Example 12, Compound (3-130) was used instead of Compound (3-52) as the material for the hole injection layer 3 and the first hole transport layer 4, and light-emitting properties were measured in the same manner. The results are collectively shown in Table 2.

### Example 17:

An organic EL device was produced according to the same conditions, except that, in Example 13, Compound (3-130) was used instead of Compound (3-52) as the material for the hole injection layer 3 and the first hole transport layer 4, and light-emitting properties were measured in the same manner. The results are collectively shown in Table 2.

### Example 18:

An organic EL device was produced according to the same conditions, except that, in Example 14, Compound (3-130) was used instead of Compound (3-52) as the material for the hole injection layer 3 and the first hole transport layer 4, and light-emitting properties were measured in the same manner. The results are collectively shown in Table 2.

### Comparative Example 1:

For comparison, an organic EL device was produced according to the same conditions, except that, in Example 1, Compound (HTM-1) was used instead of Compound (3-52) as the material for the hole injection layer 3 and the first hole transport layer 4 and Compound (HTM-2) was used instead of Compound (1-4) as the material for the second hole transport layer 5, and light-emitting properties were measured in the same manner. The results are collectively shown in Table 2.

### Comparative Example 2:

For comparison, an organic EL device was produced according to the same conditions, except that, in Example 1, Compound (HTM-1) was used instead of Compound (3-52) as the material for the hole injection layer 3 and the first hole transport layer 4 and Compound (HTM-3) was used instead of Compound (1-4) as the material for the second hole transport layer 5, and light-emitting properties were measured in the same manner. The results are collectively shown in Table 2.

### Comparative Example 3:

For comparison, an organic EL device was produced according to the same conditions, except that, in Example 1, Compound (HTM-1) was used instead of Compound (3-52) as the material for the hole injection layer 3 and the first hole transport layer 4, and light-emitting properties were measured in the same manner. The results are collectively shown in Table 2.

For the devices of the Examples and Comparative Examples, the respective results of calculating the absolute value of the difference between the HOMO level of the second hole transport layer and the HOMO level of the first hole transport layer are collectively shown in Table 1.

**[Table 1]**

| | Hole injection layer and first hole transport layer | Second hole transport layer | Absolute value of difference between HOMO level of second hole transport layer and HOMO level of first hole transport layer |
|---|---|---|---|
| Example 1 | Compound (3-52) | Compound (1-4) | 0.01 |
| Example 2 | Compound (3-52) | Compound (1-58) | 0.06 |
| Example 3 | Compound (3-52) | Compound (1-59) | 0.09 |
| Example 4 | Compound (3-52) | Compound (1-69) | 0.06 |
| Example 5 | Compound (3-52) | Compound (1-83) | 0.10 |
| Example 6 | Compound (3-130) | Compound (1-4) | 0.00 |
| Example 7 | Compound (3-130) | Compound (1-58) | 0.05 |
| Example 8 | Compound (3-130) | Compound (1-59) | 0.08 |
| Example 9 | Compound (3-130) | Compound (1-69) | 0.05 |
| Example 10 | Compound (3-130) | Compound (1-83) | 0.09 |
| Example 11 | Compound (3-52) | Compound (1-96) | 0.03 |
| Example 12 | Compound (3-52) | Compound (1-97) | 0.02 |
| Example 13 | Compound (3-52) | Compound (1-102) | 0.01 |
| Example 14 | Compound (3-52) | Compound (1-103) | 0.07 |
| Example 15 | Compound (3-130) | Compound (1-96) | 0.02 |
| Example 16 | Compound (3-130) | Compound (1-97) | 0.01 |
| Example 17 | Compound (3-130) | Compound (1-102) | 0.00 |
| Example 18 | Compound (3-130) | Compound (1-103) | 0.06 |
| Comparative Example 1 | Compound (HTM-1) | Compound (HTM-2) | 0.18 |
| Comparative Example 2 | Compound (HTM-1) | Compound (HTM-3) | 0.23 |
| Comparative Example 3 | Compound (HTM-1) | Compound (1-4) | 0.17 |

As shown in Table 1, in Examples 1 to 18, the absolute value of the difference between the HOMO level of the second hole transport layer and that of the first hole transport layer is 0.15 eV or less. In contrast, in Comparative Examples 1 to 3, the absolute value of the difference between the HOMO level of the second hole transport layer and that of the first hole transport layer is greater than 0.15 eV

The device life of each of the Examples and Comparative Examples collectively shown in Table 2 was found as follows. Constant current driving was performed, with the light emission luminance at the start of light emission (i.e., initial luminance) being 2000 cd/m², and the time it took for the light emission luminance to attenuate to 1900 cd/m² (95% attenuation: amounting to 95% when the initial luminance is considered 100%) was measured.

**[Table 2]**

| | Hole injection layer and first hole transport layer | Second hole transport layer | Voltage [V] | Luminance [cd/m²] | Luminous efficiency [cd/A] | Power efficiency [lm/W] | Device life 95% attenuation |
|---|---|---|---|---|---|---|---|
| Example 1 | Compound (3-52) | Compound (1-4) | 3.49 | 848 | 8.50 | 7.65 | 413 hours |
| Example 2 | Compound (3-52) | Compound (1-58) | 3.45 | 839 | 8.41 | 7.66 | 441 hours |
| Example 3 | Compound (3-52) | Compound (1-59) | 3.50 | 850 | 8.52 | 7.65 | 428 hours |
| Example 4 | Compound (3-52) | Compound (1-69) | 3.48 | 838 | 8.40 | 7.60 | 408 hours |
| Example 5 | Compound (3-52) | Compound (1-83) | 3.45 | 858 | 8.59 | 7.83 | 423 hours |
| Example 6 | Compound (3-130) | Compound (1-4) | 3.50 | 855 | 8.57 | 7.71 | 426 hours |
| Example 7 | Compound (3-130) | Compound (1-58) | 3.45 | 851 | 8.52 | 7.76 | 456 hours |
| Example 8 | Compound (3-130) | Compound (1-59) | 3.50 | 861 | 8.63 | 7.75 | 444 hours |
| Example 9 | Compound (3-130) | Compound (1-69) | 3.49 | 845 | 8.47 | 7.64 | 417 hours |
| Example 10 | Compound (3-130) | Compound (1-83) | 3.45 | 872 | 8.73 | 7.95 | 439 hours |
| Example 11 | Compound (3-52) | Compound (1-96) | 3.50 | 826 | 8.28 | 7.43 | 438 hours |
| Example 12 | Compound (3-52) | Compound (1-97) | 3.49 | 898 | 9.00 | 8.10 | 399 hours |
| Example 13 | Compound (3-52) | Compound (1-102) | 3.45 | 901 | 9.03 | 8.23 | 389 hours |
| Example 14 | Compound (3-52) | Compound (1-103) | 3.48 | 838 | 8.40 | 7.59 | 423 hours |
| Example 15 | Compound (3-130) | Compound (1-96) | 3.50 | 844 | 8.45 | 7.59 | 451 hours |
| Example 16 | Compound (3-130) | Compound (1-97) | 3.49 | 907 | 9.09 | 8.20 | 408 hours |
| Example 17 | Compound (3-130) | Compound (1-102) | 3.45 | 912 | 9.13 | 8.32 | 397 hours |
| Example 18 | Compound (3-130) | Compound (1-103) | 3.49 | 845 | 8.47 | 7.64 | 440 hours |
| Comparative Example 1 | Compound (HTM-1) | Compound (HTM-2) | 3.61 | 723 | 7.23 | 6.30 | 256 hours |
| Comparative Example 2 | Compound (HTM-1) | Compound (HTM-3) | 3.59 | 743 | 7.43 | 6.49 | 244 hours |
| Comparative Example 3 | Compound (HTM-1) | Compound (1-4) | 3.59 | 797 | 7.97 | 6.98 | 323 hours |

As shown in Table 2, while the voltage when a current having a current density of 10 mA/cm² was passed was 3.59 to 3.61 V for Comparative Examples 1 to 3, Examples 1 to 18 clearly had lower voltages of 3.45 to 3.50 V Further, while the luminous efficiency when a current having a current density of 10 mA/cm² was passed was 7.23 to 7.97 cd/A for Comparative Examples 1 to 3, Examples 1 to 18 clearly had higher efficiency of 8.28 to 9.13 cd/A. Furthermore, while Comparative Examples 1 to 3 had a power efficiency of 6.30 to 6.98 lm/W, Examples 1 to 18 clearly had higher efficiency of 7.43 to 8.32 lm/W. Moreover, while Comparative Examples 1 to 3 had a device life (95% attenuation) of 244 to 323 hours, Examples 1 to 18 were capable of considerably prolonging lifetime to 389 to 456 hours.

### Industrial Applicability

The organic EL device according to the present invention, which uses a triarylamine compound having a specific structure, has improved luminous efficiency compared to conventional organic EL devices, and also, the organic EL device can be improved in durability. Thus, for example, application can be expanded to home electrical appliances and lightings.

### Reference Signs List

1: Glass substrate
2: Transparent anode
3: Hole injection layer
4: First hole transport layer
5: Second hole transport layer
6: Light-emitting layer
7: Electron transport layer
8: Electron injection layer
9: Cathode
10: Capping layer

## Claims

1. An organic electroluminescence device, between an anode and a cathode comprising, at least
a first hole transport layer,
a second hole transport layer,
a light-emitting layer, and
an electron transport layer
in this order from the anode side, wherein:
the second hole transport layer contains a triarylamine compound represented by general formula (1) below; and
an absolute value of a difference between a HOMO level of the second hole transport layer and a HOMO level of the first hole transport layer is 0.15 eV or less: 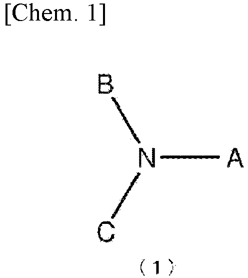
(in the formula, A represents a group represented by general formula (2-1) below;
B represents a substituted or unsubstituted aromatic hydrocarbon group, a substituted or unsubstituted aromatic heterocyclic group, or a substituted or unsubstituted fused aromatic group;
C represents a group represented by general formula (2-1) below, a substituted or unsubstituted aromatic hydrocarbon group, a substituted or unsubstituted aromatic heterocyclic group, or a substituted or unsubstituted fused aromatic group); 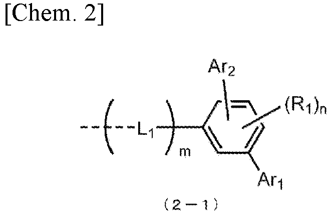
(in the formula, the broken line represents a bonding site;
R₁ represents a deuterium atom, a fluorine atom, a chlorine atom, a cyano group, a nitro group, a linear or branched alkyl group having 1 to 6 carbon atoms and optionally having a substituent, a cycloalkyl group having 5 to 10 carbon atoms and optionally having a substituent, a linear or branched alkenyl group having 2 to 6 carbon atoms and optionally having a substituent, a linear or branched alkyloxy group having 1 to 6 carbon atoms and optionally having a substituent, a cycloalkyloxy group having 5 to 10 carbon atoms and optionally having a substituent, a substituted or unsubstituted aromatic hydrocarbon group, a substituted or unsubstituted aromatic heterocyclic group, a substituted or unsubstituted fused polycyclic aromatic group, or a substituted or unsubstituted aryloxy group;
n is the number of R₁ and represents an integer from 0 to 3, wherein, when n is 2 or 3, R₁ may be the same or different from one another and the plural Ris may be bonded to each other via a single bond, a substituted or unsubstituted methylene group, an oxygen atom, or a sulfur atom, to form a ring;
L₁ represents a divalent group which is a substituted or unsubstituted aromatic hydrocarbon, a substituted or unsubstituted aromatic heterocycle or a substituted or unsubstituted fused polycyclic aromatic;
m is the number of L₁ and represents an integer from 1 to 3, wherein, when m is 2 or 3, L₁ may be the same or different from one another; and
Ar₁ and Ar₂ each independently represent a substituted or unsubstituted aromatic hydrocarbon group, a substituted or unsubstituted aromatic heterocyclic group, or a substituted or unsubstituted fused polycyclic aromatic group).

2. The organic electroluminescence device according to claim 1, wherein the group represented by the general formula (2-1) is a group represented by general formula (2-2) below: 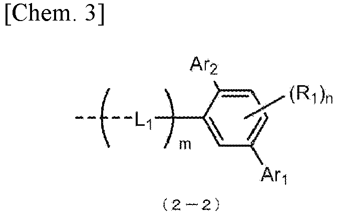 (in the formula, Ar₁, Ar₂, L₁, m, n, and R₁ have same definitions as those in the general formula (2-1)).

3. The organic electroluminescence device according to claim 1, wherein the group represented by the general formula (2-1) is a group represented by general formula (2-3) below: 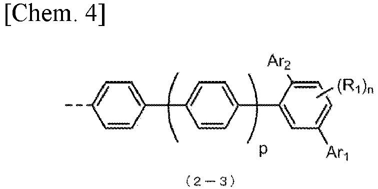
(in the formula, Ar₁, Ar₂, n, and R₁ have same definitions as those in the general formula (2-1); and
p represents 0 or 1).

4. The organic electroluminescence device according to claim 1, wherein the group represented by the general formula (2-1) is a group represented by general formula (2-4) below: 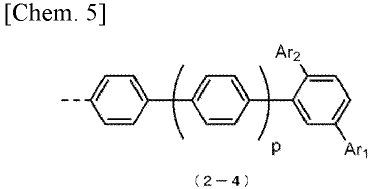
(in the formula, Ar₁ and Ar₂ have same definitions as those in the general formula (2-1); and
p represents 0 or 1).

5. The organic electroluminescence device according to any one of claims 1 to 4, wherein the first hole transport layer contains a triarylamine compound represented by general formula (3): 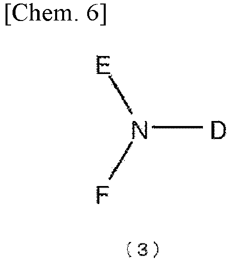
(in the formula, D, E, and F each independently represent a group represented by general formula (4-1) below, a substituted or unsubstituted aromatic hydrocarbon group, a substituted or unsubstituted aromatic heterocyclic group, or a substituted or unsubstituted fused polycyclic aromatic group, wherein at least one of D, E, and F is a group represented by general formula (4-1) below); 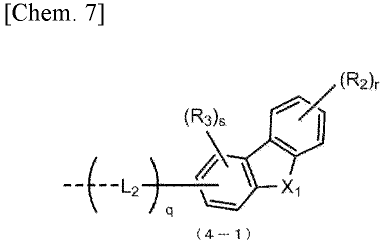
(in the formula, the broken line represents a bonding site;
L₂ represents a divalent group which is a substituted or unsubstituted aromatic hydrocarbon, a substituted or unsubstituted aromatic heterocycle, or a substituted or unsubstituted fused polycyclic aromatic;
q represents an integer from 0 to 3, wherein, when q is 2 or 3, L₂ may be the same or different from one another;
R₂ and R₃ each independently represent a deuterium atom, a fluorine atom, a chlorine atom, a cyano group, a nitro group, a linear or branched alkyl group having 1 to 6 carbon atoms and optionally having a substituent, a cycloalkyl group having 5 to 10 carbon atoms and optionally having a substituent, a linear or branched alkenyl group having 2 to 6 carbon atoms and optionally having a substituent, a linear or branched alkyloxy group having 1 to 6 carbon atoms and optionally having a substituent, a cycloalkyloxy group having 5 to 10 carbon atoms and optionally having a substituent, a substituted or unsubstituted aromatic hydrocarbon group, a substituted or unsubstituted aromatic heterocyclic group, a substituted or unsubstituted fused polycyclic aromatic group, or a substituted or unsubstituted aryloxy group;
r represents an integer from 0 to 4 and s represents an integer from 0 to 3, wherein, when r is from 2 to 4, R₂ may be the same or different from one another, when s is 2 or 3, R₃ may be the same or different from one another, and the plural R_{2S}, the plural R_{3S}, or the R₂ and the R₃ may be bonded to each other via a single bond, a substituted or unsubstituted methylene group, an oxygen atom, or a sulfur atom, to form a ring;
Xi represents O, S, NR₄, or CR₅R₆, wherein, when two or more of D, E, and F are the group represented by general formula (4-1), Xi may be the same or different from one another;
R₄ represents a deuterium atom, a fluorine atom, a chlorine atom, a cyano group, a nitro group, a linear or branched alkyl group having 1 to 6 carbon atoms and optionally having a substituent, a cycloalkyl group having 5 to 10 carbon atoms and optionally having a substituent, a linear or branched alkenyl group having 2 to 6 carbon atoms and optionally having a substituent, a linear or branched alkyloxy group having 1 to 6 carbon atoms and optionally having a substituent, a cycloalkyloxy group having 5 to 10 carbon atoms and optionally having a substituent, a substituted or unsubstituted aromatic hydrocarbon group, a substituted or unsubstituted aromatic heterocyclic group, a substituted or unsubstituted fused polycyclic aromatic group, or a substituted or unsubstituted aryloxy group; and
R₅ and R₆ each independently represent a linear or branched alkyl group having 1 to 6 carbon atoms and optionally having a substituent, a cycloalkyl group having 5 to 10 carbon atoms and optionally having a substituent, a linear or branched alkenyl group having 2 to 6 carbon atoms and optionally having a substituent, a substituted or unsubstituted aromatic hydrocarbon group, a substituted or unsubstituted aromatic heterocyclic group, a substituted or unsubstituted fused polycyclic aromatic group, or a substituted or unsubstituted aryloxy group, wherein the R₅ and the R₆ may be bonded to each other via a single bond, a substituted or unsubstituted methylene group, an oxygen atom, or a sulfur atom, to form a ring).

6. The organic electroluminescence device according to claim 5, wherein two of the D, E, and F in the general formula (3) are groups represented by the general formula (4-1), and the plural Xis each independently represent said NR₄ or CR₅R₆.

7. The organic electroluminescence device according to claim 5, wherein two of the D, E, and F in the general formula (3) are groups represented by the general formula (4-1), and one of the plural Xis is said NR₄ and the other X₁ is said CR₅R₆.

8. The organic electroluminescence device according to any one of claims 1 to 7, wherein the light-emitting layer contains a blue light-emitting dopant.

9. The organic electroluminescence device according to claim 8, wherein the blue light-emitting dopant is a compound represented by general formula (5-1) or (5-2) below: 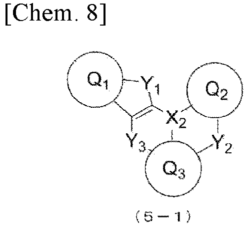 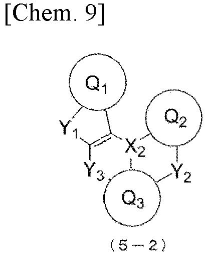
(in formulas (5-1) and (5-2), Q₁, Q₂, and Q₃ each independently represent a substituted or unsubstituted aromatic hydrocarbon or a substituted or unsubstituted aromatic heterocycle;
X₂ represents B, P, P=O, or P=S;
Y₁, Y₂, and Y₃ each independently represent N-R₇, C-R₈R₉, O, S, Se, or Si-R₁₀R₁₁;
R₇, R₈, R₉, R₁₀, and R₁₁ each independently represent a hydrogen atom, a deuterium atom, a fluorine atom, a chlorine atom, a cyano group, a nitro group, a linear or branched alkyl group having 1 to 6 carbon atoms and optionally having a substituent, a cycloalkyl group having 5 to 10 carbon atoms and optionally having a substituent, a linear or branched alkenyl group having 2 to 6 carbon atoms and optionally having a substituent, a linear or branched alkyloxy group having 1 to 6 carbon atoms and optionally having a substituent, a cycloalkyloxy group having 5 to 10 carbon atoms and optionally having a substituent, a substituted or unsubstituted aromatic hydrocarbon group, a substituted or unsubstituted aromatic heterocyclic group, or a substituted or unsubstituted aryloxy group, wherein R₈ and R₉, as well as R₁₀ and R₁₁, may be bonded to each other via a single bond, a substituted or unsubstituted methylene group, an oxygen atom, a sulfur atom, or a monosubstituted amino group, to form a ring;
when Y₁ is N-R₇, C-R₈R₉, or Si-R₁₀R₁₁, R₇, R₈, R₉, R₁₀, and R₁₁ may be bonded to Q₁ via a single bond, a substituted or unsubstituted methylene group, an oxygen atom, a sulfur atom, or a monosubstituted amino group, to form a ring;
when Y₂ is N-R₇, C-R₈R₉, or Si-R₁₀R₁₁, R₇, R₈, R₉, R₁₀, and R₁₁ may be bonded to Q₂ or Q₃ via a single bond, a substituted or unsubstituted methylene group, an oxygen atom, a sulfur atom, or a monosubstituted amino group, to form a ring; and
when Y₃ is N-R₇, C-R₈R₉, or Si-R₁₀R₁₁, R₇, R₈, R₉, R₁₀, and R₁₁ may be bonded to Q₃ via a single bond, a substituted or unsubstituted methylene group, an oxygen atom, a sulfur atom, or a monosubstituted amino group, to form a ring).

10. The organic electroluminescence device according to any one of claims 1 to 9, wherein the light-emitting layer contains an anthracene derivative having an anthracene backbone.
